(19) **Europäisches Patentamt / European Patent Office / Office européen des brevets**

(11) **EP 3 953 717 B1**

(12) **FASCICULE DE BREVET EUROPEEN**

(45) Date de publication et mention de la délivrance du brevet:
**19.07.2023  Bulletin 2023/29**

(21) Numéro de dépôt: **20715091.3**

(22) Date de dépôt: **03.04.2020**

(51) Classification Internationale des Brevets (IPC):
***G01R 22/06*** *(2006.01)*

(52) Classification Coopérative des Brevets (CPC):
**G01R 22/066; Y04S 20/30**

(86) Numéro de dépôt international:
**PCT/EP2020/059590**

(87) Numéro de publication internationale:
**WO 2020/207922 (15.10.2020 Gazette 2020/42)**

(54) **DETECTION DE FRAUDE A LA CONSOMMATION ENERGETIQUE DANS UN SERVICE DE DISTRIBUTION ELECTRIQUE**

VERFAHREN ZUR ERFASSUNG DES ENERGIEVERBRAUCHS IN EINEM STROMVERSORGUNGSDIENST

METHOD FOR DETECTING ENERGY CONSUMPTION FRAUD IN AN ELECTRICITY SUPPLY SERVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.04.2019  FR 1903749**

(43) Date de publication de la demande:
**16.02.2022  Bulletin 2022/07**

(73) Titulaire: **Sagemcom Energy & Telecom SAS**
**92500 Rueil-Malmaison (FR)**

(72) Inventeur: **TEBOULLE, Henri**
**92500 RUEIL MALMAISON (FR)**

(74) Mandataire: **Cabinet Le Guen Maillet**
**3, impasse de la Vigie**
**CS 71840**
**35418 Saint-Malo Cedex (FR)**

(56) Documents cités:
**FR-A1- 3 025 600       US-A1- 2015 149 396**
**US-A1- 2017 082 665    US-B2- 8 461 823**

**Description**

DOMAINE TECHNIQUE

La présente invention concerne des systèmes de gestion automatisée de comptage AMM (« Automated Metering Management » en anglais) dans un service de distribution électrique et plus particulièrement des détections de fraude à la consommation énergétique.

ETAT DE LA TECHNIQUE ANTERIEURE

Les réseaux de communication par courants porteurs en ligne pour des systèmes de gestion automatisée de comptage AMM ont fait leur apparition ces dernières années, notamment dans le cadre de services de distribution électrique. On peut par exemple citer le standard G3-PLC spécifié dans la recommandation ITU-T G.9903. Dans de tels réseaux de communication par courants porteurs en ligne, des communications sont établies entre des compteurs électriques, dits *compteurs électriques intelligents* (« smart electricity meters » en anglais), et un noeud concentrateur, parfois appelé *concentrateur de données* (« data concentrator » en anglais) ou *noeud de base* (« base node » en anglais) ou *coordinateur* (« coordinator » en anglais), pour permettre notamment une relève automatisée à distance de mesures de consommation électrique effectuées par lesdits compteurs électriques intelligents et pour permettre d'une manière générale une prise de contrôle à distance des compteurs électriques. Plusieurs concentrateurs de données sont alors géographiquement déployés pour répartir la charge de collecte de relevés de comptage des compteurs électriques intelligents. Chaque concentrateur de données sert alors de relais entre les compteurs électriques intelligents et une entité de gestion du système de gestion automatisée de comptage AMM qui est en charge de traiter de manière centralisée les relevés de comptage.

Ainsi, les compteurs électriques intelligents deviennent plus autonomes et permettent d'éviter à un agent de l'opérateur de distribution d'électricité de se déplacer à domicile pour effectuer régulièrement les relevés de comptage. En contrepartie, l'architecture interne des compteurs électriques se complexifie, ce qui en accroît le coût de conception, de fabrication et de maintenance. En effet, de tels compteurs électriques intelligents contrôleurs : un premier contrôleur dédié aux opérations de métrologie pour le comptage de consommation énergétique et un second contrôleur dédié aux opérations applicatives, à savoir la gestion d'interface utilisateur, la gestion calendaire et de courbes de charge, les opérations de qualimétrie et d'antifraude, et, surtout, la gestion des communications dans le système de gestion automatisée de comptage AMM. En effet, la gestion des communications dans le système de gestion automatisée de comptage AMM repose sur des encapsulations applicatives typiquement conformes au standard DLMS/COSEM (« Device Language Message Spécification / Companion Spécification for Energy Metering » en anglais), telles que décrites dans le document normatif IEC 62056-5-3 et dans la 12e édition du document « Bluebook : COSEM Interface Classes and OBIS Object Identification System » édité par le DLMS User Association, ce qui nécessite d'importantes ressources de traitement dans les compteurs électriques intelligents.

Pour pallier ces inconvénients, il est possible de concentrer les aspects applicatifs d'une pluralité de compteurs électriques dans un même compteur centralisateur. Ce compteur centralisateur joue alors un rôle de mandataire pour ladite pluralité de compteurs électriques. Le compteur centralisateur peut alors communiquer de manière beaucoup plus simple avec les compteurs électriques de ladite pluralité qu'avec le reste du système de gestion automatisée de comptage AMM, en supprimant notamment au niveau des compteurs électriques de ladite pluralité les besoins d'encapsulations applicatives évoqués ci-dessus. Cela permet de réduire le besoin en ressources de traitement des compteurs électriques en question et donc d'en simplifier la conception et d'en réduire le coût de fabrication et de maintenance. On parle alors de compteurs basiques déportés, qui sont essentiellement en charge d'effectuer des opérations métrologiques et de répondre à un jeu de commandes atomiques simple.

Cependant, il convient de pouvoir détecter des situations de fraude à la consommation énergétique malgré cette simplification structurelle des compteurs électriques permise par la mise en place de ce compteur centralisateur. La fraude à la consommation énergétique correspond à une déclaration de consommation nulle alors que l'installation électrique concernée consomme manifestement de l'énergie électrique.

Le document FR 3025600 A1 décrit un système compteur de consommation en énergie et/ou en fluide, comportant un capteur de comptage de consommation, un organe de limitation d'alimentation en énergie et/ou en fluide et une mémoire non-transitoire stockant au moins un historique de consommation.

Le document US 8,461,823 B2 décrit un procédé de mesure de l'électricité qui comprend le calcul d'un premier courant en phase accumulé indicatif d'une composante hors tension du flux d'énergie par un compteur de transformateur de distribution, le calcul d'un second courant en phase accumulé par un compteur de courant d'alimentation couplé à une ligne d'alimentation et la comparaison du premier courant en phase accumulé avec le second courant en phase accumulé pour déterminer si un vol d'électricité a eu lieu.

Le document US 2017/082665 A1 décrit des procédés, systèmes et produits de programme informatique pour détecter des pertes dans des réseaux électriques.

Le document US 2015/149396 A1 décrit un système, un procédé et un produit de programme informatique pour détecter et localiser des pertes non techniques dans un système de distribution d'énergie.

Il est notamment souhaitable de fournir une solution qui permette d'aisément identifier où est localisée la fraude parmi les compteurs basiques déportés, sans avoir à accroître leurs besoins en ressources de traitement (sinon ce serait contraire à l'objectif atteint par la mise en place du compteur centralisateur).

EXPOSE DE L'INVENTION

Un objet de la présente invention est de proposer un procédé implémenté par un dispositif, appelé compteur centralisateur, inclus dans un système de gestion automatisée de comptage dans le cadre d'un service de distribution électrique, le compteur centralisateur comportant une première unité de communication par courants porteurs en ligne configurée pour communiquer avec un concentrateur de données via un premier réseau de communication par courants porteurs en ligne dans une première bande fréquentielle et une seconde unité de communication par courants porteurs en ligne configurée pour communiquer avec une pluralité de dispositifs, appelés compteurs basiques déportés, via un second réseau de communication par courants porteurs en ligne dans une seconde bande fréquentielle distincte de la première bande fréquentielle. Le procédé comporte les étapes suivantes : émuler une application de compteur électrique intelligent vis-à-vis du concentrateur de données pour chaque compteur basique déporté enregistré auprès du compteur centralisateur via le second réseau de communication par courants porteurs en ligne, chaque application émulée construisant une courbe de charge pour le compteur basique déporté correspondant ; mesurer, par une unité de métrologie générale du compteur centralisateur, la consommation électrique de l'ensemble des installations électriques que les compteurs basiques déportés sont en charge de superviser ; et lorsque le ratio $\Delta Ea_D$ / $\Delta Ea_G$ d'une consommation énergétique $\Delta Ea_D$ déclarée par l'ensemble des compteurs basiques déportés pendant un temps T sur une consommation énergétique $\Delta Ea_G$ mesurée par l'unité de métrologie générale pendant le temps T est inférieur à un seuil prédéfini et qu'en outre les courbes de charge de plusieurs compteurs basiques déportés montrent un passage à zéro de la consommation énergétique, identifier quel compteur basique déporté est sujet à une fraude à la consommation énergétique, en extrapolant les courbes de charge desdits plusieurs compteurs basiques déportés et en comparant des consommations énergétiques globales $\Delta Ea_E$ estimées à partir des courbes de charge extrapolées avec ladite consommation énergétique $\Delta Ea_G$. Ainsi, il est possible d'aisément identifier où est localisée la fraude parmi les compteurs basiques déportés, sans avoir à accroître leurs besoins en ressources de traitement.

Selon un mode de réalisation particulier, la consommation énergétique estimée $\Delta Ea_E$ inclut une consommation intrinsèque prédéterminée $\Delta Ec$ des compteurs basiques déportés.

Selon un mode de réalisation particulier, le compteur centralisateur identifie le compteur basique déporté sujet à la fraude à la consommation énergétique comme étant le compteur basique déporté pour lequel la consommation énergétique estimée $\Delta Ea_E$ se rapproche le plus de la consommation énergétique mesurée $\Delta Ea_G$.

Selon un mode de réalisation particulier, le compteur centralisateur identifie le compteur basique déporté sujet à la fraude à la consommation énergétique comme étant le compteur basique déporté pour lequel l'expression suivante est minimale :

$$\left| 1 - \frac{\Delta Ea_E}{\Delta Ea_G} \right|$$

Selon un mode de réalisation particulier, le compteur centralisateur identifie le compteur basique déporté sujet à la fraude à la consommation énergétique comme étant le compteur basique déporté pour lequel le rapport suivant est maximal :

$$\frac{\Delta Ea_E}{\Delta Ea_G}$$

Selon un mode de réalisation particulier, lorsque les courbes de charge de plusieurs compteurs basiques déportés montrent un passage à zéro de la consommation énergétique, le compteur centralisateur effectue les étapes suivantes : récupérer des informations de l'état de chaque compteur basique déporté dont la courbe de charge montre un passage à zéro de la consommation énergétique, par envoi audit compteur basique déporté par l'application émulée instanciée pour ledit compteur basique déporté d'une trame de commande atomique dédiée ; et exclure des extrapolations la courbe de charge de chaque compteur basique déporté dont les informations d'état récupérées indiquent qu'un organe de coupure dudit compteur basique déporté est ouvert et/ou un disjoncteur de branchement de l'installation électrique que ledit compteur basique déporté est en charge de superviser est ouvert.

Selon un mode de réalisation particulier, le compteur centralisateur effectue chaque extrapolation en considérant la courbe de charge en question sur une durée égale à T/2 jusqu'au moment du passage à zéro de la consommation énergétique, où T représente une durée entre deux relevés d'index de comptage successifs par l'unité de métrologie générale pour déterminer la consommation énergétique $\Delta Ea_G$.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également un support de stockage comprenant un tel programme d'ordinateur.

L'invention concerne également un dispositif, appelé compteur centralisateur, destiné à être inclus dans un système de gestion automatisée de comptage dans le cadre d'un service de distribution électrique, le compteur centralisateur comportant une première unité de communication par courants porteurs en ligne configurée pour communiquer avec un concentrateur de données via un premier réseau de communication par courants porteurs en ligne dans une première bande fréquentielle, et une seconde unité de communication par courants porteurs en ligne configurée pour communiquer avec une pluralité de dispositifs, appelés compteurs basiques déportés, via un second réseau de communication par courants porteurs en ligne dans une seconde bande fréquentielle distincte de la première bande fréquentielle. Le compteur centralisateur comporte en outre : une unité de contrôle configurée pour émuler une application de compteur électrique intelligent vis-à-vis du concentrateur de données pour chaque compteur basique déporté enregistré auprès du compteur centralisateur via le second réseau de communication par courants porteurs en ligne, chaque application émulée construisant une courbe de charge pour le compteur basique déporté correspondant ; et une unité de métrologie générale en charge de relever la consommation électrique de l'ensemble des installations électriques que les compteurs basiques déportés sont en charge de superviser. De plus, l'unité de contrôle comporte un module de contrôle de métrologie qui, lorsque le ratio $\Delta Ea_D / \Delta Ea_G$ d'une consommation énergétique $\Delta Ea_D$ déclarée par l'ensemble des compteurs basiques déportés pendant un temps T sur une consommation énergétique $\Delta Ea_G$ mesurée par l'unité de métrologie générale pendant le temps T est inférieur à un seuil prédéfini et qu'en outre les courbes de charge de plusieurs compteurs basiques déportés montrent un passage à zéro de la consommation énergétique, est configuré pour identifier quel compteur basique déporté est sujet à une fraude à la consommation énergétique, en extrapolant les courbes de charge desdits plusieurs compteurs basiques déportés et en comparant des consommations globales $\Delta Ea_E$ estimées à partir des courbes de charge extrapolées avec ladite consommation énergétique $\Delta Ea_G$.

BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :

[Fig. 1] illustre schématiquement un système de communication, supportant une gestion automatisée de comptage, dans lequel la présente inventive est implémentée ;

[Fig. 2] illustre schématiquement un exemple d'agencement matériel d'une unité de contrôle utilisée dans le système de communication ;

[Fig. 3A] illustre schématiquement un agencement de compteur centralisateur du système de communication ;

[Fig. 3B] illustre schématiquement un agencement de compteur basique déporté du système de communication ;

[Fig. 4] illustre schématiquement des échanges entre un compteur basique déporté et un compteur centralisateur dans le système de communication ;

[Fig. 5] illustre schématiquement des échanges entre un compteur centralisateur et un concentrateur de données dans le système de communication ;

[Fig. 6] illustre schématiquement un algorithme, implémenté dans le compteur centralisateur, de détection de fraude ;

[Fig. 7] illustre schématiquement un algorithme, implémenté dans le compteur centralisateur, de mise à jour de courbes de charge ; et

[Fig. 8] illustre schématiquement un algorithme d'identification de compteur basique déporté suspecté être à l'origine de la fraude détectée.

EXPOSE DETAILLE DE MODES DE REALISATION

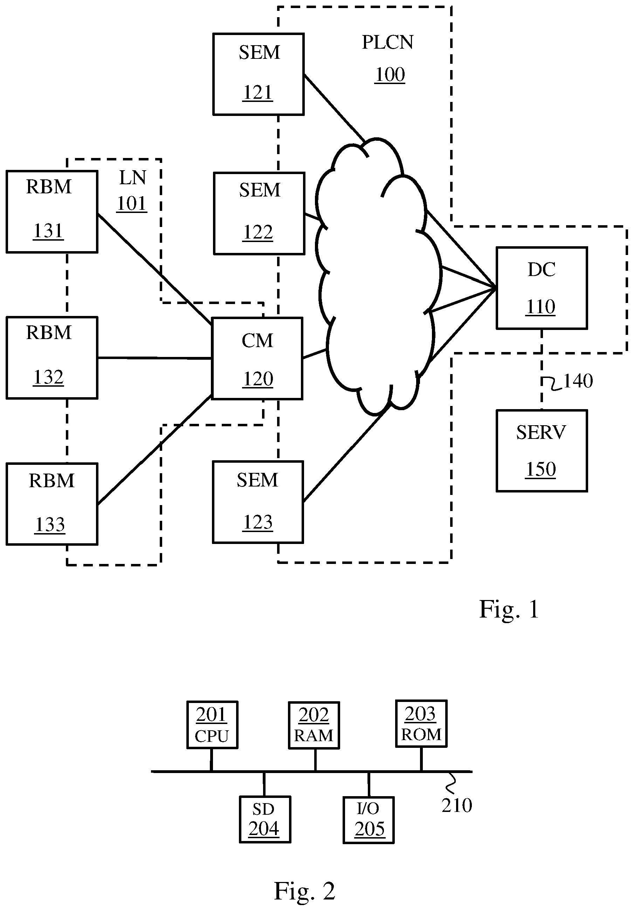

La **Fig. 1** illustre ainsi schématiquement un exemple d'un système de communication, supportant une gestion automatisée de comptage AMM dans le cadre de services de distribution électrique, dans lequel la présente invention est implémentée.

Le système de communication comporte au moins un réseau de communication par courants porteurs en ligne PLCN (« PowerLine Communications Network » en anglais) 100, simplement dénommé réseau PLCN 100 par la suite, déployé de manière logique sur un réseau d'alimentation électrique. Le réseau PLCN 100 permet la mise en place d'un système de gestion automatisée de comptage AMM dans le cadre des services de distribution électrique.

Le système de communication comporte un dispositif noeud particulier, appelé concentrateur de données DC (« data concentrator » en anglais). Le réseau PLCN 100 est destiné à permettre de connecter une pluralité de dispositifs noeuds au concentrateur de données DC 110. Les dispositifs noeuds que le réseau PLCN 100 vise à connecter au concentrateur de données DC 110 sont des compteurs électriques intelligents SEM (« smart electricity meters » en anglais) 121, 122, 123. Le réseau PLCN 100 permet ainsi d'établir des communications par courants porteurs en ligne (« powerline communications » en anglais), afin que le concentrateur de données DC 110 puisse notamment procéder automatiquement à des opérations de collecte de relevés de comptage de consommation électrique, ledit comptage étant effectué par les compteurs électriques intelligents vis-à-vis d'installations électriques que lesdits compteurs électriques intelligents sont respectivement en charge de superviser. Le réseau PLCN 100 permet notamment en outre au concentrateur de données DC 110 de procéder à des opérations de mise à jour applicative auprès des compteurs électriques intelligents, et d'une manière générale, de contrôler à distance lesdits compteurs électriques intelligents. Les communications par courants porteurs en ligne via le réseau PLCN 100 sont préférentiellement conformes au protocole G3-PLC. En variante, les communications par courants porteurs en ligne via le réseau PLCN 100 sont préférentiellement conformes aux spécifications PRIME (« "PoweRline Intelligent Metering Evolution » en anglais, telles que définies dans le document normatif ITU G.9904).

Le système de communication comporte en outre une entité de gestion du système de gestion automatisée de comptage AMM qui est notamment en charge de traiter de manière centralisée les relevés de comptage. L'entité de gestion du système de gestion automatisée de comptage AMM prend la forme d'un serveur SERV 150, ou d'un ensemble de serveurs, auquel le concentrateur de données DC 110 est connecté via un lien de communication 140. Le lien de communication 140 est un lien de communication sans-fil, par exemple de type GPRS (« General Packet Radio Service » en anglais), UMTS (« Universal Mobile Télécommunication System » en anglais) ou LTE (« Long-Term Evolution » en anglais). Le lien de communication 140 peut en variante être un lien de communication filaire.

Le concentrateur de données DC 110 effectue les opérations de collecte de relevés de comptage pour le compte du serveur SERV 150. En d'autres termes, le concentrateur de données DC 110 collecte les relevés de comptage auprès des compteurs électriques intelligents qui lui sont rattachés (*i.e.* les compteurs électriques intelligents du réseau PLCN 100), puis fournit lesdits relevés au serveur SERV 150 pour traitement. De plus, le concentrateur de données DC 110 assure préférentiellement les opérations de mise à jour applicative pour le compte du serveur SERV 150. Les opérations de mise à jour applicative sont réalisées par le concentrateur de données DC 110, bloc de données par bloc de données, auprès des compteurs électriques intelligents qui lui sont rattachés. Le concentrateur de données DC 110 gère les éventuels besoins de retransmission au sein du réseau PLCN 100 pour assurer un bon déroulement des opérations de collecte de relevés de comptage et des éventuelles opérations de mise à jour applicative. Dans un tel système de gestion automatisée de comptage AMM, le serveur SERV 150 s'appuie typiquement sur une pluralité de tels concentrateurs de données parmi lesquels l'exploitation à distance des compteurs électriques intelligents est répartie.

Le réseau PLCN 100 comporte au moins un compteur centralisateur CM (« Centralizing Meter » en anglais) 120. Le compteur centralisateur CM 120 sert de dispositif mandataire (« proxy » en anglais) pour une pluralité de compteurs basiques déportés RBM (« Remote Basic Meter » en anglais) 131, 132, 133. Du point de vue du réseau PLCN 100 et donc du concentrateur de données DC 110, les compteurs basiques déportés RBM 131, 132, 133 sont masqués par le compteur centralisateur CM 120, dans lequel sont centralisées les applications qui auraient été nécessaires aux compteurs basiques déportés RBM 131, 132, 133 pour communiquer avec le concentrateur de données DC 110 si lesdits compteurs basiques déportés RBM 131, 132, 133 avaient été directement connectés au réseau PLCN 100. Les compteurs basiques déportés RBM 131, 132, 133 sont ainsi bien moins complexes, et donc moins coûteux en termes de ressources matérielles et énergétiques, que les compteurs électriques intelligents SEM 121, 122, 123 qui sont adaptés pour communiquer avec le concentrateur de données DC 110 directement via le réseau PLCN 100.

Le compteur centralisateur CM 120 est ainsi destiné à équiper un complexe immobilier, tel qu'un immeuble ou un quartier résidentiel, dans lequel chaque local ou logement est équipé d'un compteur basique déporté RBM. Cela forme un système de comptage dédié au complexe immobilier.

Comme détaillé ci-après, le compteur centralisateur CM 120 instancie une application émulée pour chaque compteur basique déporté RBM qui lui est rattaché, chaque application émulée ainsi instanciée étant en communication avec le concentrateur de données DC 110 comme si les compteurs électriques intelligents ainsi émulés étaient localisés dans le compteur centralisateur CM 120. En d'autres termes, le compteur centralisateur CM 120 émule, vis-à-vis du concentrateur de données DC 110, un comportement de compteur électrique intelligent pour chaque compteur basique déporté RBM qui lui est rattaché. Comme détaillé ci-après, chaque compteur basique déporté RBM effectue le comptage de consommation électrique pour le logement ou local concerné, et en informe le compteur centralisateur CM auquel ledit compteur basique déporté RBM est rattaché, grâce à un protocole simplifié par rapport au protocole de communication avec le concentrateur de données DC 110. En charge alors au compteur centralisateur CM en question de gérer la complexité et la variété des échanges avec le concentrateur de données DC 110, qui sont typiquement régis par le format DLMS/COSEM (« Device Language Message Spécification / Companion Spécification for Energy Metering » en anglais), tels que décrits dans le document normatif IEC 62056-5-3 et dans la 12e édition du document « Bluebook : COSEM Interface Classes and OBIS Object Identification System » édité par le DLMS User Association, préférentiellement utilisés pour effectuer les opérations de relevé de comptage et de mise à jour applicative. Un compteur électrique intelligent dispose typiquement de plus de 500 objets COSEM parmi lesquels les courbes de charges, les calendriers, les tarifs, les index, ainsi que toutes les interfaces (organes de coupure (« breaker » en anglais), modem, Flag optique...). Le protocole DLMS permet de faire des appels de type SET et GET, ainsi que d'autres actions spécifiques sur ces objets. On peut configurer des paramètres de compteurs électriques intelligents via des appels de type SET (paramètres modem, paramètres applicatifs tels que les tarifs...), relever des courbes de charge (typiquement les courbes permettant une relève toutes les 15 minutes) via des appels de type GET, et ouvrir ou fermer leurs organes de coupure via des actions spécifiques. L'application d'un compteur électrique intelligent génère et stocke les objets COSEM et les met à jour régulièrement, les lit afin de les remonter vers le concentrateur de données DC 110 ou agit sur eux le cas échéant en fonction des échanges protocolaires avec le concentrateur de données DC 110.

Les communications entre chaque compteur basique déporté RBM 131, 132, 133 et le compteur centralisateur CM 120 sont aussi des communications par courants porteurs en ligne. Cela forme un autre réseau de communication par courants porteurs en ligne LN 101 distinct du réseau PLCN 100. Les compteurs basiques déportés RBM 131, 132, 133 sont connectés, de manière logique, directement au compteur centralisateur CM 120. Le réseau LN 101 a ainsi une topologie en étoile (« star topology » en anglais), alors que le réseau PLCN 100 a une topologie maillée (« mesh topology » en anglais), comme dans le cadre du protocole G3-PLC, ou une topologie en arbre de recouvrement (« spanning tree topology » en anglais), comme dans le cadre des spécifications PRIME.

De sorte à assurer que les compteurs basiques déportés RBM 131, 132, 133 soient masqués du concentrateur de données DC 110, des bandes fréquentielles distinctes sont utilisées. Les communications par courants porteurs en ligne sur le réseau PLCN 100 utilisent donc une première bande fréquentielle et les communications entre les compteurs basiques déportés RBM 131, 132, 133 et le compteur centralisateur CM 120 utilisent une seconde bande fréquentielle distincte de la première bande fréquentielle (i.e., qui ne se chevauche pas avec la première bande fréquentielle). Par exemple, le protocole G3-PLC et les spécifications PRIME définissent différentes bandes fréquentielles distinctes utilisables, notamment : une première bande fréquentielle CENELEC-A, qui va d'approximativement 35 kHz à 91 kHz ; une seconde bande fréquentielle FCC, qui va approximativement de 150 kHz à 480 kHz ; une troisième bande fréquentielle CENELEC-B, qui va approximativement de 98 kHz à 122 kHz. Dans un mode de réalisation préférentiel, le compteur centralisateur CM 120 utilise la bande fréquentielle CENELEC-A pour communiquer avec le concentrateur de données DC 110 et la bande fréquentielle FCC pour communiquer avec chaque compteur basique déporté RBM 131, 132, 133 géré par ledit compteur centralisateur CM 120.

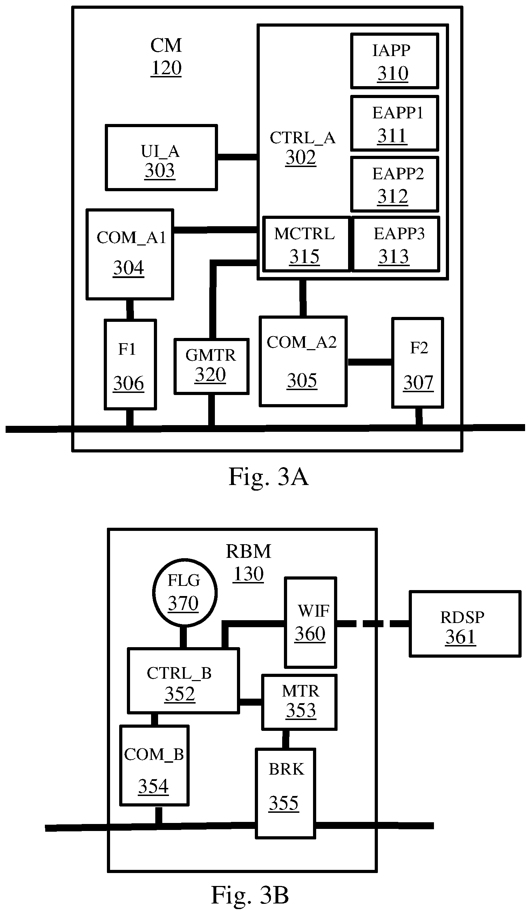

La Fig. 2 illustre schématiquement un exemple d'agencement matériel d'une unité de contrôle utilisée dans le système de communication du système de communication de la Fig. 1. Une telle unité de contrôle se retrouve dans chaque compteur basique déporté RBM 131, 132, 133 et dans le compteur centralisateur CM 120, tel que détaillé ci-après en relation avec les Figs. 3A et 3B.

L'exemple d'architecture matérielle présenté comporte, reliés par un bus de communication 210 : un processeur CPU 201 ; une mémoire vive RAM (« Random Access Memory » en anglais) 202 ; une mémoire morte ROM (« Read Only Memory » en anglais) 203 ou une mémoire Flash ; une unité de stockage ou un lecteur de support de stockage, tel qu'un lecteur de cartes SD (« Secure Digital » en anglais) 204 ; et un ensemble d'interfaces d'entrée/sortie I/O 205. L'ensemble d'interfaces de communication COM 305 permet à l'unité de contrôle d'interagir avec d'autres composantes au sein d'un même dispositif, tel que détaillé ci-après en relation avec les Figs. 3A et 3B.

Le processeur CPU 201 est capable d'exécuter des instructions chargées dans la mémoire RAM 202 à partir de la mémoire ROM 203, d'une mémoire externe (telle qu'une carte SD), d'un support de stockage ou d'un réseau de communication. Lors de la mise sous tension, le processeur CPU 201 est capable de lire de la mémoire RAM 202 des instructions et de les exécuter. Ces instructions forment un programme d'ordinateur causant la mise en oeuvre, par le processeur CPU 201, de tout ou partie des procédés et étapes décrits ici.

Ainsi, tout ou partie des procédés et étapes décrits ici peut être implémenté sous forme logicielle par exécution d'un ensemble d'instructions par une machine programmable, telle qu'un DSP (« Digital Signal Processor » en anglais) ou un microcontrôleur ou un processeur. Tout ou partie des procédés et étapes décrits ici peut aussi être implémenté sous forme matérielle par une machine ou un composant dédié, tel qu'un FPGA (« Field-Programmable Gate Array » en anglais) ou un ASIC (« Application-Specific Integrated Circuit » en anglais). Ainsi, l'unité de contrôle comporte de la circuiterie électronique adaptée et configurée pour implémenter les procédés et étapes décrits ici.

La **Fig. 3A** illustre schématiquement un agencement du compteur centralisateur CM 120, dans un mode de réalisation particulier.

Le compteur centralisateur CM 120 comporte une unité de contrôle CTRL_A 302. L'unité de contrôle CTRL_A 302 est en charge de superviser le fonctionnement du compteur centralisateur CM 120.

Le compteur centralisateur CM 120 comporte en outre une première unité de communication COM_A1 304 destinée à permettre de communiquer par courants porteurs en ligne avec le concentrateur de données DC 110 (i.e., via le réseau PLCN 100). La première unité de communication COM_A1 304 agit donc dans la première bande fréquentielle.

Le compteur centralisateur CM 120 comporte en outre une seconde unité de communication COM_A2 305 destinée à permettre de communiquer par courants porteurs en ligne avec chaque compteur basique déporté RBM rattaché au compteur centralisateur CM 120. La seconde unité de communication COM_A2 305 agit donc dans la seconde bande fréquentielle.

Dans un mode de réalisation particulier, la première unité de communication COM_A1 304 est munie d'un premier filtre F1 306 adapté et configuré pour supprimer les signaux de la bande fréquentielle des communications par courants porteurs en ligne avec la seconde unité de communication COM_A2 305. Ainsi, les communications avec le réseau PLCN 100 subissent moins d'interférences de la part des communications avec les compteurs basiques déportés RBM 131, 132, 133 rattachés au compteur centralisateur CM 120.

Dans un mode de réalisation particulier, la seconde unité de communication COM_A2 305 est munie d'un second filtre F2 307 adapté et configuré pour supprimer les signaux de la bande fréquentielle des communications par courants porteurs en ligne avec la première unité de communication COM_A1 307. Ainsi, les communications avec les compteurs basiques déportés RBM 131, 132, 133 rattachés au compteur centralisateur CM 120 subissent moins d'interférences de la part des communications au sein du réseau PLCN 100.

A noter que dans le cas d'une distribution d'alimentation électrique en triphasé, il est possible d'injecter les signaux de communication en triphasé du côté de la seconde unité de communication COM_A2 et en monophasé ou en triphasé du côté de la première unité de communication COM_A1.

Le compteur centralisateur CM 120 comporte en outre une unité de métrologie générale GMTR 320 en charge de relever la consommation électrique de l'ensemble des installations électriques que les compteurs basiques déportés RBM 131, 132, 133 rattachés au compteur centralisateur CM 120 sont en charge de superviser. Cela est possible du fait que la distribution d'alimentation électrique de ces installations électriques passe par le compteur centralisateur CM 120. L'unité de contrôle CTRL_A 302 obtient ainsi auprès de l'unité de métrologie générale GMTR 320, entre autres, des relevés d'index de comptage.

L'unité de contrôle CTRL_A 302 implémente une application interne IAPP 310. L'application interne IAPP 310 est notamment en charge d'instancier une application émulée EAPP pour chaque compteur basique déporté RBM rattaché au compteur centralisateur CM 120. Ainsi, l'unité de contrôle CTRL_A 302 comporte donc une instance d'application émulée EAPP pour chaque compteur basique déporté RBM rattaché au compteur centralisateur CM 120. De manière illustrative, comme trois compteurs basiques déportés RBM 131, 132, 133 sont rattachés au compteur centralisateur CM 120 sur la Fig. 1, la Fig. 3A montre trois applications émulées respectives EAPP 311, 312, 313.

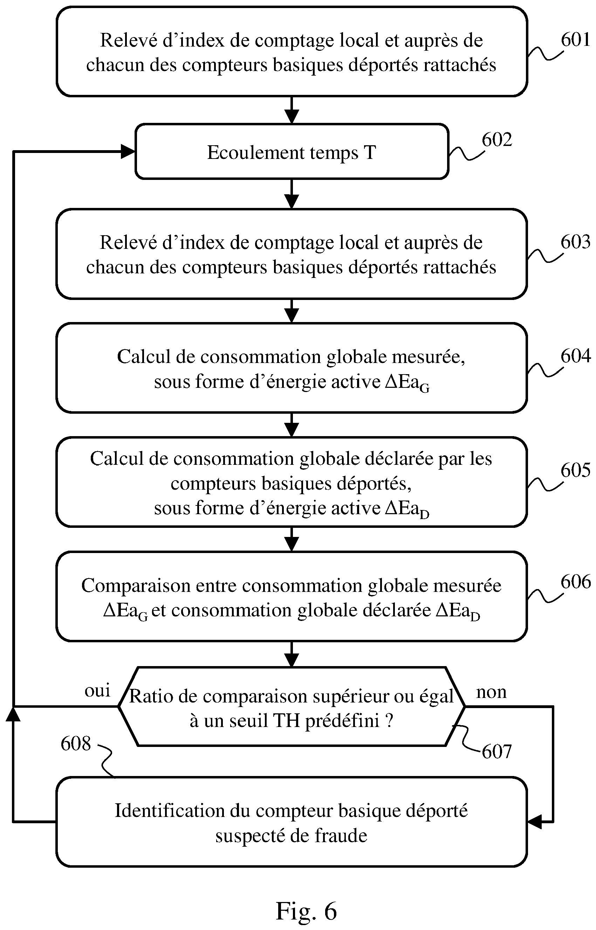

L'unité de contrôle CTRL_A 302 implémente en outre un module de contrôle de métrologie MCTRL 315 en charge d'effectuer des comparaisons entre la consommation d'énergie électrique relevée par l'unité de métrologie générale GMTR 320 et les consommations d'énergie électrique déclarées par les compteurs basiques déportés RBM 131, 132, 133 rattachés au compteur centralisateur CM 120. Plus particulièrement, le module de contrôle de métrologie MCTRL 315 utilise les relevés d'index de comptage faits par l'unité de métrologie générale GMTR 320 et ceux déclarés par lesdits compteurs basiques déportés RBM 131, 132, 133 afin de détecter d'éventuelles situations de fraude à la consommation énergétique. Cet aspect est détaillé ci-après en relation avec les Figs. 6 à 8.

Le compteur centralisateur CM 120 peut comporter en outre une unité d'interface utilisateur UI_A 303 adaptée pour interagir avec des utilisateurs. Dans un mode de réalisation particulier, l'unité d'interface utilisateur UI_A 303 comporte un afficheur permettant notamment d'afficher des relevés d'index de comptage correspondant aux compteurs basiques déportés RBM 131, 132, 133 rattachés au compteur centralisateur CM 120. L'unité d'interface utilisateur UI_A 303 comporte un panneau de contrôle adapté pour permettre aux utilisateurs de saisir un mot de passe. Chaque compteur basique déporté RBM 131, 132, 133 rattaché au compteur centralisateur CM 120 dispose de son propre mot de passe. L'unité de contrôle CTRL_A 302 est en charge de vérifier que le mot de passe saisi pour un compteur basique déporté RBM 131, 132, 133 correspond à un mot de passe attendu pour ledit compteur basique déporté RBM 131, 132, 133, et si tel est le cas, l'unité de contrôle CTRL_A 302 récupère le relevé d'index de comptage auprès de l'instance de l'application émulée EAPP correspondant audit compteur basique déporté RBM 131, 132, 133 et instruit l'unité d'interface utilisateur UI_A 303 d'afficher sur l'afficheur le relevé d'index de comptage récupéré. Un mot de passe par défaut est défini de manière déterministe pour chaque compteur basique déporté RBM 131, 132, 133. Le mot de passe de chaque compteur basique déporté RBM 131, 132, 133 peut être changé auprès du compteur centralisateur CM 120 grâce à l'unité d'interface utilisateur UI_A 303, le mot de passe ainsi changé étant alors mémorisé par le compteur centralisateur CM 120 en association avec l'instance de l'application émulée EAPP correspondante.

Contrairement aux compteurs basiques déportés RBM, le compteur centralisateur CM 120 ne comporte préférentiellement pas d'organe de coupure. En effet, le rôle du compteur centralisateur CM 120 n'est pas d'effectuer des opérations de protection des installations électriques, mais de centraliser l'intelligence applicative, et donc les ressources matérielles afférentes, pour le compte des compteurs basiques déportés RBM.

La **Fig. 3B** illustre schématiquement un agencement de compteur basique déporté RBM 130. Les compteurs basiques déportés RBM 131, 132, 133 sont agencés conformément à ce compteur basique déporté RBM 130, dans un mode de réalisation particulier.

Le compteur basique déporté RBM 130 comporte une unité de contrôle CTRL_B 352. L'unité de contrôle CTRL_B 352 est en charge de superviser le fonctionnement du compteur basique déporté RBM 130.

Le compteur basique déporté RBM 130 comporte en outre une unité de métrologie MTR 353 en charge de relever la consommation électrique de l'installation électrique que le compteur basique déporté RBM 130 est en charge de superviser. L'unité de contrôle CTRL_B 352 obtient ainsi auprès de l'unité de métrologie MTR 353, entre autres, des relevés d'index de comptage.

Le compteur basique déporté RBM 130 comporte en outre un organe de coupure BRK 355. L'organe de coupure BRK 355 est un coupe-circuit contrôlable à distance par l'opérateur et qui permet d'activer et de désactiver à volonté l'alimentation électrique de l'installation électrique supervisée par le compteur basique déporté RBM 130.

Le compteur basique déporté RBM 130 comporte en outre une unité de communication COM_B 354 destinée à permettre de communiquer par courants porteurs en ligne avec le compteur centralisateur CM auquel ledit compteur basique déporté RBM 130 est rattaché. L'unité de communication COM_B 354 agit dans la seconde bande fréquentielle.

Le compteur basique déporté RBM 130 comporte préférentiellement en outre une interface de communication optique FLG 370 permettant à un opérateur humain de venir brancher une sonde conforme au standard IEC 62056-21, aussi connue sous le nom de sonde « Flag ». Une telle sonde est reliée à un terminal mis à la disposition de l'opérateur humain, et permet d'effectuer un relevé d'index de comptage auprès du compteur basique déporté RBM 130 et éventuellement de modifier la configuration du compteur basique déporté RBM 130. Le compteur basique déporté RBM 130 comporte alors une rondelle métallique entourant un premier émetteur-récepteur optique (« optical transceiver » en anglais), et la sonde comporte une rondelle aimantée entourant un second émetteur-récepteur optique. L'agencement est tel que, lorsque l'opérateur humain utilise la sonde, la rondelle aimantée se place contre la rondelle métallique, de sorte que les premier et second émetteurs-récepteurs optiques sont en regard l'un de l'autre. Cet agencement permet de faciliter la mise en place de la sonde sur le compteur basique déporté RBM 130. Le compteur basique déporté RBM 130 peut comporter dans l'unité de contrôle CTRL_B 352 une zone mémoire adaptée pour stocker des relevés d'index de comptage fournis par intervalles réguliers de durée prédéfinie (e.g., toutes les 5 minutes) par l'unité de métrologie MTR 353 sur une plage temporelle prédéfinie (e.g., pendant les 2 derniers jours). L'opérateur humain peut alors récupérer, grâce à l'interface de communication optique FLG 370, les relevés d'index de comptage ainsi stockés.

Contrairement au compteur centralisateur CM 120, le compteur basique déporté RBM 130 ne comporte pas d'interface utilisateur (éventuellement quelques diodes électroluminescentes d'état de fonctionnement) et notamment pas d'afficheur. Cependant, le compteur basique déporté RBM 130 comporte préférentiellement en outre une interface de communication sans-fil WIF 360 adaptée et configurée pour transmettre des informations à afficher sur un afficheur distant (« remote display » en anglais) RDSP 361. Un tel afficheur distant RDSP 361 est typiquement installé dans le logement ou local dont l'installation électrique est supervisée par le compteur basique déporté RBM 130 en question. L'interface de communication sans-fil WIF 360 est par exemple de type WiFi, Zigbee, ou KNX-RF (i.e., KNX sur couche physique radiofréquence) tel que défini dans le standard ISO/IEC 14543. Les informations à afficher sur l'afficheur distant sont indiquées au compteur basique déporté RBM 130 par le compteur centralisateur CM 120 grâce à une commande spécifique, comme décrit ci-après.

A noter que dans un mode de réalisation particulier, un filtre du même type que le filtre F2 307 peut être intercalé entre l'unité de communication COM_B 354 et la ligne d'alimentation électrique.

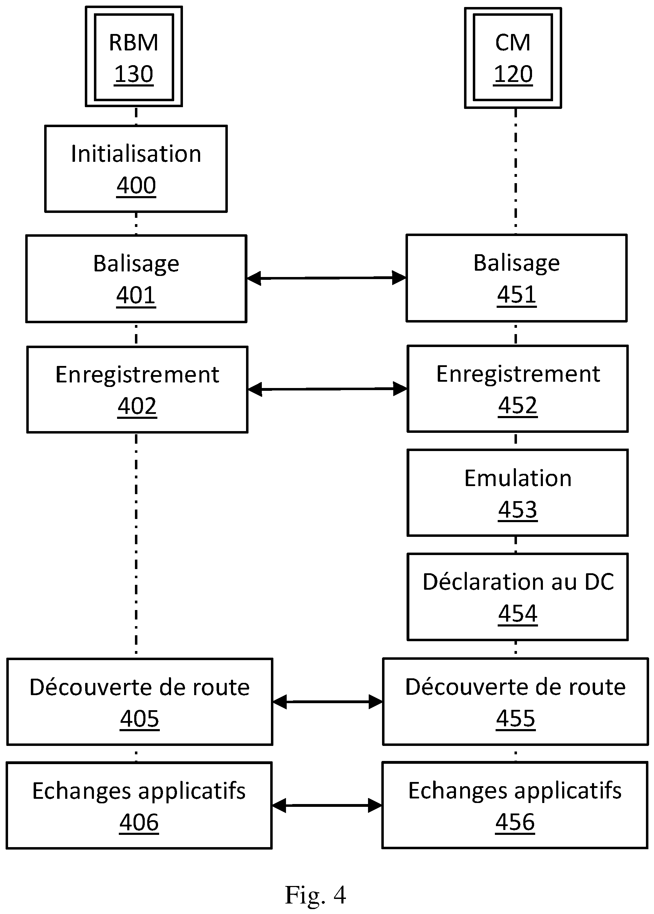

La **Fig. 4** illustre schématiquement des échanges entre un dit compteur basique déporté RBM 130 et le compteur centralisateur CM 120 auquel ledit compteur basique déporté RBM 130 doit être rattaché.

Dans une étape 400, le compteur basique déporté RBM 130 s'initialise, par exemple suite à une installation par un installateur agréé.

Dans une étape 401, le compteur basique déporté RBM 130 effectue une opération de balisage en coopération avec le compteur centralisateur CM 120 (étape 451). L'opération de balisage consiste pour le compteur basique déporté RBM 130 à détecter la présence du compteur centralisateur CM auquel se rattacher.

Dans un exemple de réalisation calqué sur le comportement du protocole 6LoWPAN (« IPv6 Low power Wireless Personal Area Networks » en anglais, tel que spécifié dans les documents normatifs RFC 4919 et 4944) utilisé dans le cadre du protocole G3-PLC, l'opération de balisage comporte la diffusion (« broadcast » en anglais) d'une requête de balisage (« beacon request » en anglais) par le compteur basique déporté RBM 130. Chaque dispositif connecté au réseau de distribution électrique captant la requête de balisage diffusée est supposé y répondre en mode point-à-point (« unicast » en anglais). Le compteur centralisateur CM 120 y répond. En effet, le réseau de distribution électrique est tel que la distance de câble électrique entre le compteur basique déporté RBM 130 et le compteur centralisateur CM 120 auquel ledit compteur basique déporté RBM 130 est supposé se rattacher est inférieure à la portée des communications par courants porteurs en ligne spécifiées pour les compteurs basiques déportés RBM.

D'autres compteurs basiques déportés RBM peuvent capter la requête de balisage diffusée. Dans un mode de réalisation, les compteurs basiques déportés RBM sont configurés pour répondre aux requêtes de balisage. Dans leur réponse, les compteurs basiques déportés RBM fournissent une information représentative du nombre de sauts qui les séparent du coordinateur de leur réseau, à savoir le compteur centralisateur CM auquel ils sont rattachés. Cela peut donc se faire de manière indirecte grâce à des informations de coût de route, dans la mesure où le routage est configuré de manière à ce qu'à un coût de route donné corresponde un et un seul nombre de sauts. Par exemple : un coût de route < 7 correspond à 0 saut, de 7 à 13 correspond à 1 saut, de 14 à 26 à 2 sauts, etc. Les compteurs basiques déportés RBM susceptibles de répondre ont déjà été enregistrés, et le nombre de sauts qui les séparent de leur compteur centralisateur CM est ainsi égal à « 1 » (connexion logique directe). Les compteurs basiques déportés RBM sont alors configurés pour écarter toute réponse qui indique un nombre non nul de sauts pour atteindre le coordinateur de réseau, à savoir le compteur centralisateur CM auquel ils sont supposés se rattacher. Dans un mode de réalisation, préférentiel, les compteurs basiques déportés RBM sont configurés pour ne pas répondre aux requêtes de balisage, et donc seul le compteur centralisateur CM 120 répond aux requêtes de balisage émis par les compteurs basiques déportés RBM qui sont susceptibles de lui être rattachés.

Dans une étape 402, le compteur basique déporté RBM 130 effectue une opération d'enregistrement en coopération avec le compteur centralisateur CM 120 (étape 452). L'opération d'enregistrement consiste à confirmer auprès du compteur centralisateur CM 120 que ledit compteur basique déporté RBM 130 a identifié le compteur centralisateur CM 120 comme étant son point de rattachement et à confirmer que le compteur centralisateur CM 120 a pris en compte l'apparition dudit compteur basique déporté RBM 130. Pendant l'opération d'enregistrement, le compteur centralisateur CM 120 et ledit compteur basique déporté RBM 130 s'authentifient mutuellement. Préférentiellement, pendant l'opération d'enregistrement, le compteur centralisateur CM 120 transmet audit compteur basique déporté RBM 130 des informations de sécurisation de communication destinées à sécuriser les échanges ultérieurs entre le compteur centralisateur CM 120 et ledit compteur basique déporté RBM 130.

Dans un exemple de réalisation calqué sur le comportement du protocole EAP-PSK (« Extensible Authentication Protocol with Pre-Shared Key » en anglais, tel que défini dans le document normatif RFC 4764) utilisé dans le cadre du protocole G3-PLC, le compteur basique déporté RBM 130 transmet au compteur centralisateur CM 120 une requête d'adhésion (« join request » en anglais), ce qui entraîne une première requête d'identification (« challenge request » en anglais) de la part du compteur centralisateur CM 120 à destination dudit compteur basique déporté RBM 130. Cette première requête d'identification inclut un premier nombre aléatoire, ainsi qu'un identifiant qui identifie le compteur centralisateur CM 120. Ledit compteur basique déporté RBM 130 transmet en retour une première réponse d'identification (« challenge response » en anglais) qui inclut un second nombre aléatoire, ainsi qu'un identifiant dudit compteur basique déporté RBM 130 et un premier résultat de calcul. Le premier résultat de calcul résulte d'une exécution de fonction prédéfinie prenant en entrée le premier nombre aléatoire, le second nombre aléatoire et une clef secrète PSK (« Pre-Shared Key » en anglais) connue dudit compteur basique déporté RBM 130 et du compteur centralisateur CM 120. La vérification du premier résultat de calcul par le compteur centralisateur CM 120 permet d'authentifier ledit compteur basique déporté RBM 130. Ensuite, le compteur centralisateur CM 120 transmet audit compteur basique déporté RBM 130 une seconde requête d'identification, qui inclut un second résultat de calcul. Le second résultat de calcul résulte d'une exécution de fonction prédéfinie prenant en entrée le second nombre aléatoire et la clef secrète PSK. La vérification du second résultat de calcul par ledit compteur basique déporté RBM 130 permet d'authentifier le compteur centralisateur CM 120. La seconde requête d'identification contient préférentiellement, sous forme chiffrée, une clef de chiffrement GMK_CC qui est utilisée par la suite pour chiffrer les échanges entre ledit compteur basique déporté RBM 130 et le compteur centralisateur CM 120.

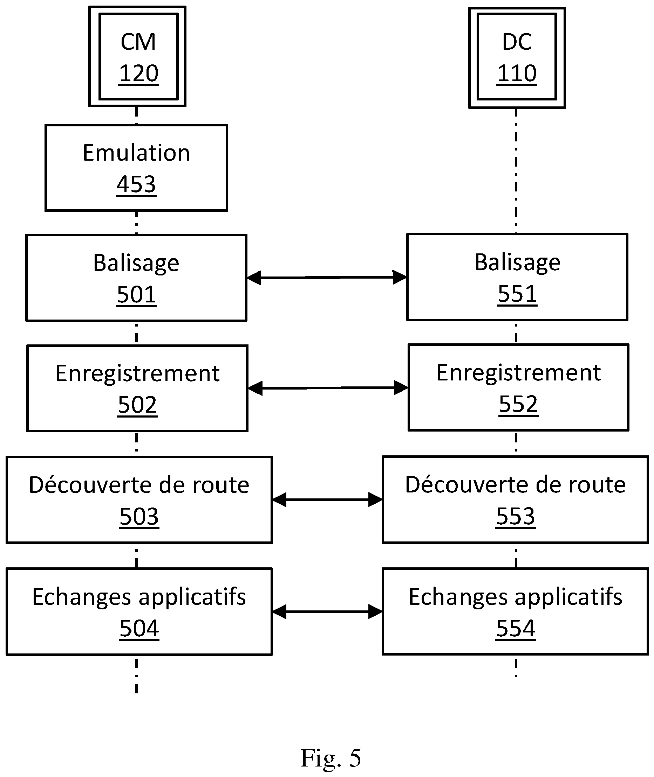

En conséquence de l'enregistrement par le compteur centralisateur CM 120 dudit compteur basique déporté RBM 130 dans l'étape 452, le compteur centralisateur CM 120 instancie une application émulée EAPP pour ledit compteur basique déporté RBM 130 dans une étape 453. Puis, dans une étape 454, le compteur centralisateur CM 120 déclare, grâce à ladite application émulée EAPP, ledit compteur basique déporté RBM 130 auprès du concentrateur de données DC 110. Un mode de réalisation est détaillé ci-après en relation avec la Fig. 5. Le concentrateur de données DC 110 voit ainsi ledit compteur basique déporté RBM 130 comme si ledit compteur basique déporté RBM 130 était un compteur électrique intelligent, avec des fonctionnalités complètes, directement implémenté par le compteur centralisateur CM 120.

Dans une étape 455 (qui peut se dérouler en parallèle de l'étape 453 et/ou de l'étape 454), le compteur centralisateur CM 120 effectue une opération de découverte de route en collaboration avec ledit compteur basique déporté RBM 130 (étape 405). L'opération de découverte de route consiste à mettre à jour des tables de routage respectives du compteur centralisateur CM 120 et dudit compteur basique déporté RBM 130 pour finaliser leur mise en communication.

Dans un exemple de réalisation calqué sur le comportement du protocole LOADng (« Lightweight On-demand Ad-hoc Distance-vector routing protocol - next génération » en anglais) utilisé dans le cadre du protocole G3-PLC, le compteur centralisateur CM 120 diffuse une requête de route (« route request » en anglais). La requête de route cible ledit compteur basique déporté RBM 130 et demande de découvrir quel chemin utiliser pour communiquer avec ledit compteur basique déporté RBM 130. Ledit compteur basique déporté RBM 130 transmet en retour, en mode point-à-point, une réponse de route (« route reply » en anglais). Le compteur centralisateur CM 120 et ledit compteur basique déporté RBM 130 mettent alors à jour leurs tables de routage respectives en indiquant que ledit compteur centralisateur CM 120 et ledit compteur basique déporté RBM 130 sont en connexion directe (i.e., un seul saut). Cette approche simplifie le déploiement des compteurs basiques déportés RBM 130 en réutilisant les mécanismes de routage communément utilisés dans le cadre des systèmes de gestion automatisée de comptage AMM.

Ensuite, dans une étape 456, le compteur centralisateur CM 120 est apte à mettre en place des échanges applicatifs, préférentiellement sécurisés, avec ledit compteur basique déporté RBM 130 (étape 406). Comme déjà évoqué, ces échanges applicatifs sont préférentiellement chiffrés grâce à la clef de chiffrement GMK_CC.

Grâce à ces échanges applicatifs, le compteur centralisateur CM 120 est apte à transmettre des trames de commandes atomiques audit compteur basique déporté RBM 130 et à recevoir en retour des trames de réponse de la part dudit compteur basique déporté RBM 130.

Cela permet que le compteur centralisateur CM 120 et les compteurs basiques déportés RBM qui lui sont rattachés n'aient à interagir que pour traiter des commandes atomiques de métrologie et de gestion de coupe-circuit, alors que les sollicitations applicatives en provenance du concentrateur de données DC 110 requièrent des traitements substantiellement plus complexes, tels que des traitements analytiques, des mises en forme et des encapsulations. Les commandes atomiques relèvent de mises à l'heure dudit compteur basique déporté RBM 130, d'ordres d'ouverture de l'organe de coupure BRK 355, d'ordres de fermeture de l'organe de coupure BRK 355, d'ordres d'envoi d'un relevé d'index de comptage, et de demandes de rapports sur l'état dudit compteur basique déporté RBM 130.

Lorsque ledit compteur basique déporté RBM 130 comporte l'interface de communication sans-fil WIF 360 afin de permettre l'utilisation de l'afficheur distant RDSP 361, le compteur centralisateur CM 120 est apte à ordonner un affichage sur ledit afficheur distant RDSP 361 d'une chaîne de caractères fournie en argument.

Chaque trame de commande atomique comporte par exemple un octet de commande, suivi éventuellement de données utiles (« payload data » en anglais) de taille prédéterminée en fonction de la commande en question. Par exemple, l'octet de commande prend les valeurs suivantes, les autres valeurs étant réservées pour de futurs usages :

0x01 : Commande de mise à l'heure, suivie de 6 octets de données utiles pour indiquer l'année, le mois, le jour, l'heure, la minute et la seconde courants ;
0x02 : Commande d'ouverture de l'organe de coupure BRK 355 ;
0x03 : Commande de fermeture de l'organe de coupure BRK 355 ;
0x04 : Commande d'envoi de relevé d'index de comptage ;
0x05 : Commande d'envoi d'état dudit compteur basique déporté RBM 130 ; et
0x06 : Commande d'affichage sur afficheur distant, suivie de 1 octet indiquant la taille M d'une chaîne de caractères à afficher, ainsi que de M octets contenant la chaîne de caractères à afficher.

Sur réception d'une telle trame de commande atomique, le compteur basique déporté RBM 130 effectue la commande en question ; la trame de réponse indique si la prise en compte de la commande a été un succès ou un échec. Chaque trame de réponse comporte par exemple un octet de réponse, suivi éventuellement de données utiles de taille prédéfinie en fonction de la commande ayant entraîné la réponse en question. Par exemple, l'octet de réponse prend les valeurs suivantes, les autres valeurs étant réservées pour de futurs usages :

0x01 : Acquittement simple ;
0x02 : Fourniture de relevé d'index de comptage, suivie de 4 octets d'index de comptage et de 6 octets d'horodatage correspondant ; et
0x03 : Fourniture d'état, suivie de 1 octet de statut.

Par exemple, l'octet de statut prend les valeurs suivantes :

0x00 : OK
0x01 : Fraude magnétique suspectée ;
0x02 : Fraude par contournement (« bypass » en anglais) suspectée ;
0x03 : Anomalie métrologique détectée ;
0x04 : Echauffement anormal détecté ; et
0x05 : Autre panne détectée.

Deux bits peuvent être réservés dans l'octet de statut pour indiquer les états du coupe-circuit opérateur BRK 355 et d'un disjoncteur de branchement DBRK placé en entrée de l'installation électrique que le compteur basique déporté RBM en question est en charge de superviser :

1 bit : Organe de coupure BRK 355 ouvert (« 0 ») / fermé (« 1 ») ; et
1 bit : Disjoncteur de branchement DBRK (« Downstream Breaker » en anglais) ouvert (« 0 ») / fermé (« 1 »).

Le compteur basique déporté RBM est capable de déterminer si le disjoncteur de branchement DBRK est ouvert ou fermé grâce à une mesure de tension en entrée de l'installation électrique que le compteur basique déporté RBM en question est en charge de superviser. Cette mesure de tension peut être faite par l'unité de métrologie MTR 353.

La **Fig. 5** illustre schématiquement des échanges entre le compteur centralisateur CM 120 et le concentrateur de données DC 110 via le réseau PLCN 100.

Suite à l'instanciation par le compteur centralisateur CM 120 d'une application émulée EAPP pour un dit compteur basique déporté RBM 130 dans l'étape 453, le compteur centralisateur CM 120 déclare, grâce à ladite application émulée EAPP, ledit compteur basique déporté RBM 130 auprès du concentrateur de données DC 110. Ainsi, dans une étape 501, le compteur centralisateur CM 120 effectue une opération de balisage en coopération avec le concentrateur de données DC 110 (étape 551). L'opération de balisage consiste à identifier pour l'application émulée EAPP en question comment se rattacher au réseau PLCN 100 pour être déclarée auprès du concentrateur de données DC 110. Comme pour l'algorithme de la Fig. 4, le protocole 6LoWPAN peut être utilisé ici. Une différence réside toutefois en ce que, dans le réseau PLCN 100, un ou plusieurs compteurs électriques intelligents SEM peuvent servir de relais pour atteindre le concentrateur de données DC 110.

Dans une étape 502, ladite application émulée EAPP effectue une opération d'enregistrement en coopération avec le concentrateur de données DC 110 (étape 552). L'opération d'enregistrement consiste à confirmer auprès du concentrateur de données DC 110 que ladite application émulée EAPP a identifié un point de rattachement au réseau PLCN 100 et à confirmer que le concentrateur de données DC 110 a pris en compte l'apparition du compteur électrique intelligent émulé par ladite application émulée EAPP. Pendant l'opération d'enregistrement, le concentrateur de données DC 110 et ladite application émulée EAPP s'authentifient mutuellement. Comme pour l'algorithme de la Fig. 4, le protocole EAP-PSK peut être utilisé ici.

Dans une étape 553, le concentrateur de données DC 110 effectue une opération de découverte de route en collaboration avec ladite application émulée EAPP (étape 503). L'opération de découverte de route consiste à mettre à jour des tables de routage respectives du concentrateur de données DC 110 et de ladite application émulée EAPP pour finaliser leur mise en communication. Comme pour l'algorithme de la Fig. 4, le protocole LOADng peut être utilisé ici. A noter que, dans ce cas, chaque application émulée EAPP instanciée au sein du compteur centralisateur CM 120 dispose de sa propre table de routage vis-à-vis du réseau PLCN 100.

Ensuite, dans une étape 504, le concentrateur de données DC 110 est apte à mettre en place des échanges applicatifs, préférentiellement sécurisés, avec ladite application émulée (étape 554).

Ainsi, grâce à son unité de contrôle CTRL_A 302 et aux applications émulées EAPP, le compteur centralisateur CM 120 est apte à répondre à des sollicitations applicatives du concentrateur de données DC 110 vis-à-vis des compteurs basiques déportés RBM 131, 132, 133 dans le cadre du service de distribution électrique, en commandant les compteurs basiques déportés RBM 131, 132, 133 grâce à un jeu de commandes atomiques de métrologie et de gestion de coupe-circuit. L'essentiel des traitements applicatifs qui requiert l'essentiel des ressources matérielles de traitement usuellement requises dans les compteurs électriques intelligents est ainsi mutualisé au sein du compteur centralisateur CM 120 pour les compteurs basiques déportés RBM 131, 132, 133.

La **Fig. 6** illustre schématiquement un algorithme de détection de fraude. L'algorithme de la Fig. 6 est implémenté par le compteur centralisateur CM 120 et plus particulièrement par le module de contrôle de métrologie MCTRL 315 de l'unité de contrôle CTRL_A 302.

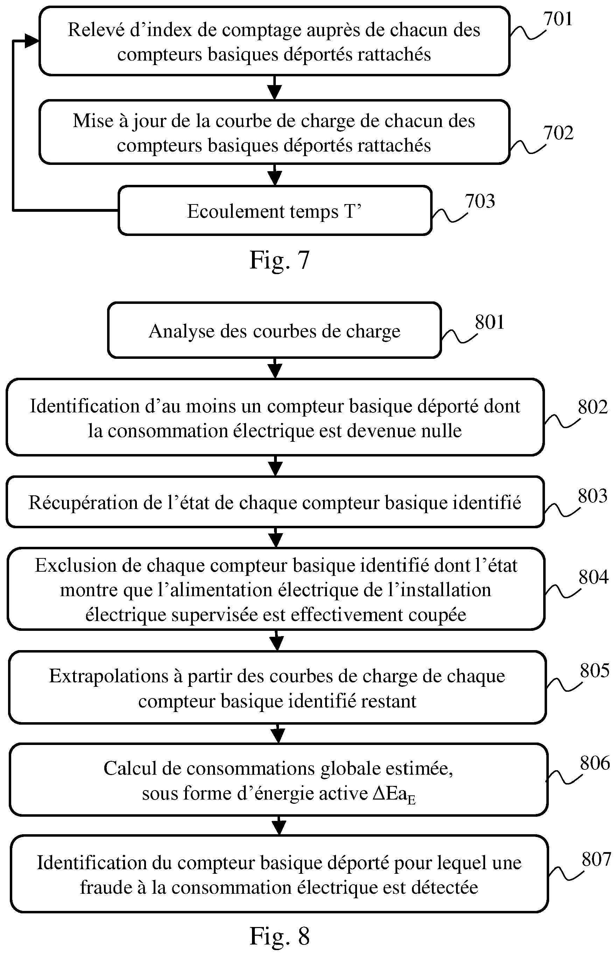

Dans une étape 601, le module de contrôle de métrologie MCTRL 315 obtient un relevé d'index de comptage local, c'est-à-dire de la part de l'unité de métrologie générale GMTR 320, ainsi qu'un relevé d'index de comptage auprès de chaque compteur basique déporté RBM qui est rattaché au compteur centralisateur CM 120. Chaque relevé d'index de comptage auprès d'un dit compteur basique déporté RBM est obtenu par envoi d'une trame de commande atomique audit compteur basique déporté RBM par l'application émulée EAPP instanciée pour ledit compteur basique déporté RBM. En retour, chaque compteur basique déporté RBM transmet une trame de réponse qui inclut le relevé d'index de comptage demandé. L'obtention des relevés d'index de comptage auprès des compteurs basiques déportés RBM 131, 132, 133 peut se faire dans le cadre d'une constitution de courbes de charge, tel que décrit ci-après en relation avec la Fig. 7.

Dans une étape 602, le module de contrôle de métrologie MCTRL 315 attend l'écoulement d'un temps prédéfini T qui correspond à un pas temporel prédéfini de surveillance de l'exactitude des relevés d'index de comptage effectués par les compteurs basiques déportés RBM 131, 132, 133 rattachés au compteur centralisateur CM 120. Par exemple, le temps prédéfini T est de 60 minutes. Puis, dans une étape 603, le module de contrôle de métrologie MCTRL 315 effectue les mêmes opérations que dans l'étape 601.

Dans une étape 604, le module de contrôle de métrologie MCTRL 315 effectue un calcul de consommation globale mesurée, sous forme d'énergie active $\Delta Ea_G$. Le calcul de consommation globale mesurée est effectué grâce aux relevés d'index de comptage locaux des étapes 601 et 603, et représente la différence d'index de comptage entre ces deux relevés d'index de comptage locaux. Lors des prochaines itérations de l'étape 604, le même calcul est effectué grâce aux relevés d'index de comptage locaux des itérations consécutives de l'étape 603.

Dans une étape 605, le module de contrôle de métrologie MCTRL 315 effectue un calcul de consommation globale déclarée, sous forme d'énergie active $\Delta Ea_D$. Le calcul de consommation globale déclarée est effectué en sommant des calculs de consommation individuelle $\{(\Delta Ea_D)_K\}_{K=1,...,N}$ (où N est le nombre de compteurs basiques déportés RBM 131, 132, 133 rattachés au compteur centralisateur CM 120) déclarée par chacun des compteurs basiques déportés RBM 131, 132, 133 rattachés au compteur centralisateur CM 120. On a donc :

$$\Delta Ea_D = \sum_{K=1}^{N} (\Delta Ea_D)_K$$

Chaque calcul de consommation individuelle déclarée $(\Delta Ea_D)_K$ est effectué grâce aux relevés d'index de comptage obtenus auprès du compteur basique déporté RBM considéré dans les étapes 601 et 603, et représente la différence d'index de comptage entre ces deux relevés d'index de comptage (nouvel index - ancien index). Lors des prochaines itérations de l'étape 604, les mêmes calculs sont effectués grâce aux relevés d'index de comptage obtenus auprès du compteur basique déporté RBM considéré dans les itérations consécutives de l'étape 603.

Dans une étape 606, le module de contrôle de métrologie MCTRL 315 effectue une comparaison entre la consommation globale déclarée $\Delta Ea_D$, et la consommation globale mesurée $\Delta Ea_G$, et plus particulièrement sur la base du ratio $\Delta Ea_D / \Delta Ea_G$. Dans un mode de réalisation particulier, cette comparaison s'effectue entre, d'une part, la somme de la consommation globale déclarée $\Delta Ea_D$ et une consommation intrinsèque prédéterminée $\Delta Ec$ des compteurs basiques déportés RBM 131, 132, 133 rattachés au compteur concentrateur CM 120, et, d'autre part, la consommation globale mesurée $\Delta Ea_G$. Cela signifie que le ratio $\Delta Ec / \Delta Ea_G$ est considéré en plus du ratio $\Delta Ea_D / \Delta Ea_G$. La consommation intrinsèque prédéterminée $\Delta Ec$ est typiquement égale au produit entre le nombre N de compteurs basiques déportés RBM 131, 132, 133 rattachés au compteur centralisateur CM 120 et une valeur de consommation intrinsèque connue $\Delta E_{RBM}$ du modèle de compteur basique déporté RBM. Par exemple, le module de contrôle de métrologie MCTRL 315 compare le ratio suivant par rapport à un seuil prédéfini TH1, par exemple égal à 95% :

$$(\Delta Ea_D + \Delta E_C)\Big/ \Delta Ea_G$$

Dans un autre mode de réalisation particulier, la comparaison s'effectue directement entre la consommation globale déclarée $\Delta Ea_D$ et la consommation globale mesurée $\Delta Ea_G$. Par exemple, le module de contrôle de métrologie MCTRL 315 compare le ratio entre la consommation globale déclarée $\Delta Ea_D$ et la consommation globale mesurée $\Delta Ea_G$ par rapport à un autre seuil prédéfini TH2 qui prend lui-même en compte la consommation intrinsèque prédéterminée $\Delta Ec$ des compteurs basiques déportés RBM 131, 132, 133 rattachés au compteur concentrateur CM 120.

Dans une étape 607, le module de contrôle de métrologie MCTRL 315 vérifie si le ratio de comparaison de la consommation globale déclarée $\Delta Ea_D$ sur la consommation globale mesurée $\Delta Ea_G$ est supérieur ou égal à un seuil prédéfini TH. Si tel est le cas, l'étape 602 est répétée ; sinon, une étape 608 est effectuée. En reprenant les modes de réalisation particuliers mentionnés ci-dessus, le module de contrôle de métrologie MCTRL 315 vérifie si le ratio entre, d'une part, la somme de la consommation globale déclarée $\Delta Ea_D$ et une consommation intrinsèque prédéterminée $\Delta Ec$ des compteurs basiques déportés RBM 131, 132, 133 rattachés au compteur concentrateur CM 120, et, d'autre part, la consommation globale mesurée $\Delta Ea_G$, est inférieur au seuil prédéfini TH1, ou si le ratio entre la consommation globale déclarée $\Delta Ea_D$ et la consommation globale mesurée $\Delta Ea_G$ est inférieur au seuil prédéfini TH2.

Dans l'étape 608, le module de contrôle de métrologie MCTRL 315 considère qu'il y a une fraude à la consommation énergétique de l'un desdits compteurs basiques déportés RBM 131, 132, 133, et le module de contrôle de métrologie MCTRL 315 identifie le compteur basique déporté RBM qui est suspecté de fraude. L'identification du compteur basique déporté RBM suspecté de fraude est détaillée ci-après en relation avec la Fig. 8.

La **Fig. 7** illustre schématiquement un algorithme de mise à jour de courbe de charge d'au moins un compteur basique déporté RBM. L'algorithme de la Fig. 7 est implémenté par le compteur centralisateur CM 120 et plus particulièrement par l'application émulée EAPP de chaque compteur basique déporté RBM qui est rattaché au compteur centralisateur CM 120.

La courbe de charge définit l'évolution de la consommation énergétique de l'installation électrique supervisée pendant une durée prédéfinie, et donc de l'énergie et de la puissance électrique consommées pendant cette durée prédéfinie. La courbe de charge est constituée d'un relevé d'index de comptage à intervalles réguliers selon un pas (« step » en anglais) temporel de mesure prédéfini, par exemple toutes les 5 minutes.

Ainsi, dans une étape 701, chaque application émulée EAPP en question effectue un relevé d'index de comptage auprès du compteur basique déporté RBM pour lequel ladite application émulée EAPP a été instanciée. Cette opération est effectuée par l'envoi d'une trame de commande atomique demandant l'envoi d'un relevé d'index de comptage. En retour, chaque compteur basique déporté RBM rattaché au compteur centralisateur CM 120 transmet une trame de réponse qui inclut le relevé d'index de comptage demandé.

Dans une étape 702, chaque application émulée EAPP en question effectue une mise à jour de la courbe de charge associée au compteur basique déporté RBM. Comme déjà évoqué, la courbe de charge de chaque compteur basique déporté RBM rattaché au compteur centralisateur CM 120 est construite et stockée par l'application émulée EAPP instanciée pour ledit compteur basique déporté RBM. Chaque courbe de charge donne ainsi, de manière échantillonnée, une représentation de l'évolution de la consommation énergétique qui est déclarée par ledit compteur basique déporté RBM via ses relevés successifs d'index de comptage.

Dans une étape 703, chaque application émulée EAPP en question attend l'écoulement d'un temps T' qui correspond au pas temporel entre deux relevés d'index de comptage successifs pour un même compteur basique déporté RBM. Ensuite, l'étape 701 est répétée.

A noter que les différentes applications émulées EAPP instanciées par l'unité de contrôle CTRL_A 302 demandent les relevés d'index de comptage auprès de leurs compteurs basiques déportés RBM respectifs, de manière décalée dans le temps. Cela limite les risques de collision de transmissions de trames dans le réseau de communication par courants porteurs en ligne LN 101.

Les courbes de charge ainsi obtenues sont plus particulièrement utilisées, lorsqu'une fraude à la consommation électrique est détectée, pour identifier quel compteur basique déporté RBM supervise l'installation électrique à l'origine de ladite fraude, tel que détaillé ci-après en relation avec la Fig. 8.

La **Fig. 8** illustre schématiquement un algorithme d'identification de compteur basique déporté RBM suspecté être à l'origine de la fraude détectée. L'algorithme de la Fig. 8 est implémenté par le compteur centralisateur CM 120 et plus particulièrement par le module de contrôle de métrologie MCTRL 315 de l'unité de contrôle CTRL_A 302.

Dans une étape 801, le module de contrôle de métrologie MCTRL 315 effectue une analyse des courbes de charge des compteurs basiques déportés RBM rattachés au compteur concentrateur CM 120. L'analyse comporte une phase de repérage d'un éventuel passage à zéro de la consommation énergétique d'au moins un des compteurs basiques déportés RBM.

Dans une étape 802, le module de contrôle de métrologie MCTRL 315 identifie au moins un compteur basique déporté RBM rattaché au compteur centralisateur CM 120, pour lequel la courbe de charge concernée montre que la consommation énergétique est devenue nulle (pas d'évolution de l'index de comptage). Ce passage à zéro de la consommation énergétique déclarée par un dit compteur basique déporté RBM ne s'est pas nécessairement produit pendant la période de temps T entre les deux relevés d'index de comptage qui ont permis de détecter la fraude, mais peut s'être produit dans la période de temps T précédente (mais n'a pas eu suffisamment d'impact cumulé sur le ratio de la consommation globale déclarée $\Delta Ea_D$ sur la consommation globale mesurée $\Delta Ea_G$ pour avoir été détecté dans la période de temps T précédente). Le module de contrôle de métrologie MCTRL 315 analyse ainsi préférentiellement les courbes de charge sur la période de temps T entre les deux relevés d'index de comptage qui ont permis de détecter la fraude et sur la période de temps T précédente. Si un seul et unique compteur basique déporté RBM ressort de l'étape 802, le module de contrôle de métrologie MCTRL 315 a identifié le compteur basique déporté RBM sujet à la fraude à la consommation énergétique, et il est mis fin à l'algorithme (non représenté sur la Fig. 8). Sinon, les compteurs basiques déportés RBM sont mis dans une liste L de compteurs basiques déportés RBM potentiellement sujets à la fraude à la consommation énergétique.

Dans une étape 803, le module de contrôle de métrologie MCTRL 315 récupère des informations de l'état de chaque compteur basique déporté RBM identifié à l'étape 802, qui sont obtenues par envoi d'une trame de commande atomique audit compteur basique déporté RBM par l'application émulée EAPP instanciée pour ledit compteur basique déporté RBM. En retour, chaque compteur basique déporté RBM concerné transmet une trame de réponse qui inclut les informations de l'état dudit compteur basique déporté RBM. Notamment, la trame de réponse comporte des informations indiquant si l'organe de coupure est ouvert ou fermé, et des informations indiquant si ledit compteur basique déporté RBM concerné a détecté que le disjoncteur de branchement DBRK de l'installation électrique que ledit compteur basique déporté RBM est en charge de superviser est ouvert ou fermé.

Dans une étape 804, le module de contrôle de métrologie MCTRL 315 exclut de la liste L tout compteur basique déporté RBM dont l'état, tel qu'obtenu à l'étape 803, montre que l'alimentation électrique de l'installation électrique supervisée par ledit compteur basique déporté RBM a été coupée par ouverture de l'organe de coupure BRK 355 dudit compteur basique déporté RBM et/ou du disjoncteur de branchement DBRK de ladite installation électrique. En effet, pour tout compteur basique déporté RBM ainsi exclus, le passage à zéro de la consommation électrique est alors considéré comme étant lié à la coupure de l'alimentation électrique de l'installation électrique supervisée par ledit compteur basique déporté RBM. Si un seul et unique compteur basique déporté RBM reste dans la liste L à l'issue de l'étape 804, le module de contrôle de métrologie MCTRL 315 a identifié le compteur basique déporté RBM sujet à la fraude à la consommation énergétique, et il est mis fin à l'algorithme (non représenté sur la Fig. 8).

Dans une étape 805, le module de contrôle de métrologie MCTRL 315 effectue des extrapolations des courbes de charge des compteurs basiques déportés RBM restant dans la liste L. Les extrapolations consistent à estimer quelles auraient été les consommations énergétiques desdits compteurs basiques déportés RBM s'il n'y avait pas eu de passage à zéro. Dans un mode de réalisation particulier, le module de contrôle de métrologie MCTRL 315 effectue chaque extrapolation en considérant la courbe de charge en question sur une durée égale à T/2 jusqu'au moment de leur passage à zéro de la consommation énergétique.

Dans une étape 806, le module de contrôle de métrologie MCTRL 315 effectue un calcul de consommation globale estimée, sous forme d'énergie active $\Delta Ea_E$, à partir de chaque extrapolation effectuée dans l'étape 805. Cela donne autant de calculs de consommation globale estimée $\Delta Ea_E$ qu'il n'y a de compteurs basiques déportés RBM dans la liste L. La consommation globale estimée $\Delta Ea_E$ calculée peut inclure la consommation intrinsèque prédéterminée $\Delta Ec$ des compteurs basiques déportés RBM 131, 132, 133 effectivement rattachés au compteur concentrateur CM 120.

Dans une étape 807, le module de contrôle de métrologie MCTRL 315 identifie quel est le compteur basique déporté RBM dans la liste L concerné par la fraude à la consommation énergétique détectée, à savoir le compteur basique déporté RBM de la liste L pour lequel la consommation globale estimée $\Delta Ea_E$ se rapproche le plus de la consommation globale mesurée $\Delta Ea_G$ (telle que déterminée dans le cadre de l'algorithme de la Fig. 6). Dans un mode de réalisation particulier, le module de contrôle de métrologie MCTRL 315 recherche pour ce faire le compteur basique déporté RBM de la liste L pour lequel l'expression suivante est minimale :

$$\left| 1 - \frac{\Delta Ea_E}{\Delta Ea_G} \right|$$

Dans encore un mode de réalisation particulier, le module de contrôle de métrologie MCTRL 315 identifie quel est le compteur basique déporté RBM dans la liste L concerné par la fraude à la consommation énergétique détectée, en recherchant le compteur basique déporté RBM de la liste L pour lequel le rapport suivant est maximal :

$$\frac{\Delta Ea_E}{\Delta Ea_G}$$

Il est donc supposé qu'il n'y a qu'un seul et unique fraudeur parmi les compteurs basiques déportés RBM 131, 132, 133 rattachés au compteur centralisateur CM 120, dans la mesure où il peut être raisonnablement supposé que, dans le cas de plusieurs fraudes parallèles et indépendantes, les instants de débuts des fraudes ne sont pas corrélés et encore moins simultanés. Ainsi, lorsque le ratio de la consommation énergétique déclarée $\Delta Ea_D$ par l'ensemble des compteurs basiques déportés RBM 131, 132, 133 pendant le temps T sur la consommation énergétique $\Delta Ea_G$ mesurée par l'unité de métrologie générale GMTR 320 pendant le temps T est inférieur au seuil prédéfini TH et lorsqu'en outre les courbes de charge de plusieurs de ces compteurs basiques déportés RBM montrent un passage à zéro de la consommation énergétique, le module de contrôle de métrologie MCTRL 315 identifie quel compteur basique déporté RBM est sujet à une fraude à la consommation énergétique, en extrapolant les courbes de charge desdits plusieurs compteurs basiques déportés RBM et en comparant les consommations globales $\Delta Ea_E$ estimées à partir des courbes de charge extrapolées avec la consommation énergétique $\Delta Ea_G$ mesurée par l'unité de métrologie générale GMTR 320.

## Revendications

1. Procédé implémenté par un dispositif, appelé compteur centralisateur (120), inclus dans un système de gestion automatisée de comptage dans le cadre d'un service de distribution électrique, le compteur centralisateur (120) comportant une première unité de communication (304) par courants porteurs en ligne configurée pour communiquer avec un concentrateur de données (110) via un premier réseau de communication par courants porteurs en ligne (100) dans une première bande fréquentielle, le compteur centralisateur (120) comportant en outre une seconde unité de communication (305) par courants porteurs en ligne configurée pour communiquer avec une pluralité de dispositifs, appelés compteurs basiques déportés (131, 132, 133), via un second réseau de communication par courants porteurs en ligne (101) dans une seconde bande fréquentielle distincte de la première bande fréquentielle, le procédé comportant les étapes suivantes :

   - émuler une application de compteur électrique intelligent (311, 312, 313) vis-à-vis du concentrateur de données (110) pour chaque compteur basique déporté (131, 132, 133) enregistré auprès du compteur centralisateur (120) via le second réseau de communication par courants porteurs en ligne (101), chaque application émulée (311, 312, 313) construisant une courbe de charge pour le compteur basique déporté (131, 132, 133) correspondant,
   - mesurer, par une unité de métrologie générale (320) du compteur centralisateur (120), la consommation électrique de l'ensemble des installations électriques que les compteurs basiques déportés (131, 132, 133) sont en charge de superviser,
   - lorsque le ratio $\Delta Ea_D$ / $\Delta Ea_G$ d'une consommation énergétique $\Delta Ea_D$ déclarée par l'ensemble des compteurs basiques déportés (131, 132, 133) pendant un temps T sur une consommation énergétique $\Delta Ea_G$ mesurée par l'unité de métrologie générale (320) pendant le temps T est inférieur à un seuil prédéfini et qu'en outre les courbes de charge de plusieurs compteurs basiques déportés (131, 132, 133) montrent un passage à zéro de la consommation énergétique, identifier quel compteur basique déporté (131, 132, 133) est sujet à une fraude à la consommation énergétique, en extrapolant les courbes de charge desdits plusieurs compteurs basiques déportés (131, 132, 133) et en comparant des consommations énergétiques globales $\Delta Ea_E$ estimées à partir des courbes de charge extrapolées avec ladite consommation énergétique $\Delta Ea_G$.

2. Procédé selon la revendication 1, dans lequel la consommation énergétique estimée $\Delta Ea_E$ inclut une consommation intrinsèque prédéterminée $\Delta Ec$ des compteurs basiques déportés (131, 132, 133).

3. Procédé selon l'une des revendications 1 et 2, dans lequel le compteur centralisateur (120) identifie (807) le compteur basique déporté sujet à la fraude à la consommation énergétique comme étant le compteur basique déporté pour lequel la consommation énergétique estimée $\Delta Ea_E$ se rapproche le plus de la consommation énergétique mesurée $\Delta Ea_G$.

4. Procédé selon la revendication 3, dans lequel le compteur centralisateur (120) identifie (807) le compteur basique déporté sujet à la fraude à la consommation énergétique comme étant le compteur basique déporté pour lequel l'expression suivante est minimale :

$$\left| 1 - \frac{\Delta Ea_E}{\Delta Ea_G} \right|$$

5. Procédé selon l'une des revendications 1 et 2, dans lequel le compteur centralisateur (120) identifie (807) le compteur basique déporté sujet à la fraude à la consommation énergétique comme étant le compteur basique déporté pour lequel le rapport suivant est maximal :

$$\frac{\Delta Ea_E}{\Delta Ea_G}$$

6. Procédé selon l'une quelconque des revendications 1 à 5, dans lequel lorsque les courbes de charge de plusieurs compteurs basiques déportés (131, 132, 133) montrent un passage à zéro de la consommation énergétique, le compteur centralisateur (120) effectue les étapes suivantes :

- récupérer des informations de l'état de chaque compteur basique déporté dont la courbe de charge montre un passage à zéro de la consommation énergétique, par envoi audit compteur basique déporté par l'application émulée (311, 312, 313) instanciée pour ledit compteur basique déporté (131, 132, 133) d'une trame de commande atomique dédiée, et
- exclure des extrapolations la courbe de charge de chaque compteur basique déporté dont les informations d'état récupérées indiquent qu'un organe de coupure dudit compteur basique déporté est ouvert et/ou un disjoncteur de branchement de l'installation électrique que ledit compteur basique déporté est en charge de superviser est ouvert.

7. Procédé selon l'une quelconque des revendications 1 à 6, dans lequel le compteur centralisateur effectue chaque extrapolation en considérant la courbe de charge en question sur une durée égale à T/2 jusqu'au moment du passage à zéro de la consommation énergétique, où T représente une durée entre deux relevés d'index de comptage successifs par l'unité de métrologie générale (320) pour déterminer la consommation énergétique $\Delta Ea_G$.

8. Dispositif, appelé compteur centralisateur (120), destiné à être inclus dans un système de gestion automatisée de comptage dans le cadre d'un service de distribution électrique, le compteur centralisateur (120) comportant une première unité de communication (304) par courants porteurs en ligne configurée pour communiquer avec un concentrateur de données (110) via un premier réseau de communication par courants porteurs en ligne (100) dans une première bande fréquentielle, le compteur centralisateur (120) comportant en outre :

- une seconde unité de communication (305) par courants porteurs en ligne configurée pour communiquer avec une pluralité de dispositifs, appelés compteurs basiques déportés (131, 132, 133), via un second réseau de communication par courants porteurs en ligne (101) dans une seconde bande fréquentielle distincte de la première bande fréquentielle,
- une unité de contrôle (302) configurée pour émuler une application de compteur électrique intelligent (311, 312, 313) vis-à-vis du concentrateur de données (110) pour chaque compteur basique déporté (131, 132, 133) enregistré auprès du compteur centralisateur (120) via le second réseau de communication par courants porteurs en ligne (101), chaque application émulée (311, 312, 313) construisant une courbe de charge pour le compteur basique déporté (131, 132, 133) correspondant,
- une unité de métrologie générale (320) en charge de relever la consommation électrique de l'ensemble des installations électriques que les compteurs basiques déportés (131, 132, 133) sont en charge de superviser,

l'unité de contrôle (302) comportant un module de contrôle de métrologie (315) qui, lorsque le ratio $\Delta Ea_D / \Delta Ea_G$ entre une consommation énergétique $\Delta Ea_D$ déclarée par l'ensemble des compteurs basiques déportés (131, 132, 133) pendant un temps T et une consommation énergétique $\Delta Ea_G$ mesurée par l'unité de métrologie générale (320) pendant le temps T est inférieur à un seuil prédéfini et qu'en outre les courbes de charge de plusieurs compteurs basiques déportés (131, 132, 133) montrent un passage à zéro de la consommation énergétique, est configuré pour identifier quel compteur basique déporté (131, 132, 133) est sujet à une fraude à la consommation énergétique, en extrapolant les courbes de charge desdits plusieurs compteurs basiques déportés (131, 132, 133) et en comparant des consommations globales $\Delta Ea_E$ estimées à partir des courbes de charge extrapolées avec ladite consommation énergétique $\Delta Ea_G$.

9. Produit programme d'ordinateur comportant des instructions qui conduisent le dispositif (120) selon la revendication 8, à exécuter les étapes du procédé selon l'une quelconque des revendications 1 à 7.

10. Support de stockage stockant sur lequel est enregistré le programme d'ordinateur selon la revendication 9.

**Patentansprüche**

1. Verfahren, das von einer Vorrichtung implementiert wird, die als zentraler Zähler (120) bezeichnet wird. Diese Vorrichtung ist in einem automatisierten Zählerverwaltungssystem im Rahmen eines elektrischen Verteilungsdienstes enthalten, wobei der zentrale Zähler (120) eine erste Kommunikationseinheit (304) über Powerline (PLC - Power Line Communications) umfasst. Diese ist zum Kommunizieren mit einem Datenkonzentrator (110) über ein erstes Powerline-Kommunikationsnetzwerk (100) in einem ersten Frequenzband konfiguriert. Zudem umfasst der zentrale Zähler (120) eine zweite Kommunikationseinheit (305) über Powerline (PLC - Power Line Communications), die zum Kommunizieren mit einer Vielzahl von Geräten, die als Remote-Basiszähler (131, 132, 133) bezeichnet werden, über ein zweites Powerline-Kommunikationsnetzwerk (101) in einem zweiten Frequenzband konfiguriert ist. Das zweite Frequenzband unterscheidet sich deutlich von dem ersten Frequenzband, wobei das Verfahren die folgenden Schritte umfasst:

- die Nachahmung einer intelligenten Anwendung für Stromzähler (311, 312, 313) gegenüber dem Datenkonzentrator (110) für jeden Remote-Basiszähler (131, 132, 133), der bei dem zentralen Zähler (120) über das zweite Powerline-Kommunikationsnetzwerk (101) registriert ist, wobei jede emulierte Anwendung (311, 312, 313) eine Lastkurve für den entsprechenden Remote-Basiszähler (131, 132, 133) errichtet,
- die Messung durch eine allgemeine Metrologieeinheit (320) des zentralen Zählers (120) des Energieverbrauchs aller elektrischen Anlagen, für deren Überwachung die Remote-Basiszähler (131, 132, 133) zuständig sind,
- wenn das Verhältnis $\Delta EaD / \Delta EaG$ eines Energieverbrauchs $\Delta EaD$, der von allen Remote-Basiszähler (131, 132, 133) für eine Zeit T angegeben wird, zu einem Energieverbrauch $\Delta EaG$, der von der allgemeinen Metrologieeinheit (320) während der Zeit T gemessen wird, kleiner ist als ein vordefinierter Schwellenwert und wenn außerdem die Lastkurven mehrerer Remote-Basiszähler (131, 132, 133) einen Nulldurchgang des Energieverbrauchs anzeigen, muss identifiziert werden, welcher Remote-Basiszähler (131, 132, 133) einem Energieverbrauchsbetrug ausgesetzt ist. Diese erfolgt durch Extrapolation der Lastkurven der betroffenen mehreren Remote-Basiszähler (131, 132, 133) und durch Vergleich des aus den extrapolierten Lastkurven geschätzten Gesamtenergieverbrauchs $\Delta EaE$ mit dem Energieverbrauch $\Delta EaG$.

2. Verfahren nach Anspruch 1, bei dem der geschätzte Energieverbrauch $\Delta EaE$ einen vorbestimmten Eigenverbrauch $\Delta Ec$ der Remote-Basiszähler (131, 132, 133) enthält.

3. Verfahren nach einem der Ansprüche 1 und 2, bei dem der zentrale Zähler (120) den Remote-Basiszähler, der einem Energieverbrauchsbetrug ausgesetzt ist, als den Remote Basiszähler identifiziert (807), für den der geschätzte Energieverbrauch $\Delta EaE$ dem gemessenen Energieverbrauch $\Delta EaG$ am nächsten kommt.

4. Verfahren nach Anspruch 3, beim dem der zentrale Zähler (120) den Remote-Basiszähler, der einem Energieverbrauchsbetrug ausgesetzt ist, als den Remote-Basiszähler identifiziert (807), für den der folgende Ausdruck minimal ist:

$$\left| 1 - \frac{\Delta Ea_E}{\Delta Ea_G} \right|$$

**5.** Verfahren nach einem der Ansprüche 1 und 2, bei dem der zentrale Zähler (120) den Remote-Basiszähler, der einem Energieverbrauchsbetrug ausgesetzt ist, als den Remote-Basiszähler identifiziert (807), für den das folgende Verhältnis maximal ist:

$$\frac{\Delta Ea_E}{\Delta Ea_G}$$

**6.** Verfahren nach einem der Ansprüche 1 bis 5, bei dem, wenn die Lastkurven mehrerer Remote-Basiszähler (131, 132, 133) einen Nulldurchgang des Energieverbrauchs anzeigen, der zentrale Zähler (120) die folgenden Schritte ausführt:

- Abrufen der Informationen zum Zustand jedes Remote-Basiszählers, dessen Lastkurve einen Nulldurchgang des Energieverbrauchs anzeigt. Dies erfolgt durch Senden eines dedizierten atomaren Steuerungsrahmens an den Remote-Basiszähler durch die emulierte Anwendung (311, 312, 313), die für den Remote-Basiszähler (131, 132, 133) instantiiert wurde, und
- Ausschluss der Extrapolation der Lastkurve jedes Remote-Basiszählers, dessen abgerufene Zustandsinformationen anzeigen, dass ein Schutzschalter des Remote-Basiszähler und/oder ein Netzanschlusstrennschalter der elektrischen Anlage, für die der Remote-Basiszähler zuständig ist, offen ist.

**7.** Verfahren nach einem der Ansprüche 1 bis 6, bei dem der zentrale Zähler jede Extrapolation unter Berücksichtigung der betreffenden Lastkurve über einen Zeitraum gleich T/2 bis zum Zeitpunkt des Nulldurchgangs des Energieverbrauchs ausführt. T stellt dabei eine Dauer zwischen zwei aufeinanderfolgenden Zählerstandsablesungen durch die allgemeine Metrologieeinheit (320) dar, um den Energieverbrauch ΔEaG zu bestimmen.

**8.** Vorrichtung, die als zentraler Zähler (120) bezeichnet wird. Diese Vorrichtung soll in einem automatisierten Zählerverwaltungssystem im Rahmen eines elektrischen Verteilungsdienstes enthalten sein, wobei der zentrale Zähler (120) eine erste Kommunikationseinheit (304) über Powerline (PLC - Power Line Communications) umfasst. Diese ist zum Kommunizieren mit einem Datenkonzentrator (110) über ein erstes Powerline-Kommunikationsnetzwerk (100) in einem ersten Frequenzband konfiguriert. Wobei der zentrale Zähler (120) ferner Folgendes umfasst:

- eine zweite Kommunikationseinheit (305) über Powerline (PLC - Power Line Communications), die zum Kommunizieren mit einer Vielzahl von Geräten, die als Remote-Basiszähler (131, 132, 133) bezeichnet werden, über ein zweites Powerline-Kommunikationsnetzwerk (101) in einem zweiten Frequenzband konfiguriert ist, welches sich deutlich von dem ersten Frequenzband unterscheidet,
- eine Steuereinheit (302), die dazu konfiguriert ist, eine intelligente Anwendung für Stromzähler (311, 312, 313) gegenüber dem Datenkonzentrator (110) für jeden Remote-Basiszähler (131, 132, 133) zu emulieren, der sich bei dem zentralen Zähler (120) über das zweite Powerline-Kommunikationsnetzwerk (101) registriert ist, wobei jede emulierte Anwendung (311, 312, 313) eine Lastkurve für den entsprechenden Remote-Basiszähler (131, 132, 133) errichtet,
- eine allgemeine Metrologieeinheit (320), die für die Aufzeichnung des Stromverbrauchs aller elektrischen Anlagen zuständig ist, die von den Remote-Basiszählern (131, 132, 133) überwacht werden.

Wobei die Steuereinheit (302) ein metrologisches Steuermodul (315) umfasst, das, wenn das Verhältnis ΔEaD / ΔEaG zwischen einem Energieverbrauch ΔEaD, der von allen Remote-Basiszählern (131, 132, 133) für eine Zeit T angegeben wird und ein Energieverbrauch ΔEaG, der von der allgemeinen Metrologieeinheit (320) während der Testzeit gemessen wird, unter einem vordefinierten Schwellenwert liegt und wenn außerdem die Lastkurven mehrerer Remote-Basiszähler (131, 132, 133) einen Nulldurchgang des Energieverbrauchs zeigen, so konfiguriert ist, dass sie identifizieren kann, welche der Remote-Basiszähler (131, 132, 133) einem Energieverbrauchsbetrug ausgesetzt ist. Dies erfolgt durch die Extrapolation der Lastkurven der betroffenen mehreren Remote-Basiszähler (131, 132, 133) und durch Vergleich des aus den extrapolierten Lastkurven geschätzten Gesamtenergieverbrauchs ΔEaE mit dem Energieverbrauch ΔEaG.

**9.** Computerprogrammprodukt mit Anweisungen, die die Vorrichtung (120) nach Anspruch 8 veranlassen, die Schritte des Verfahrens nach einem der Ansprüche 1 bis 7 auszuführen.

**10.** Speichermedium, auf dem das Computerprogramm nach Anspruch 9 aufgezeichnet ist.

**Claims**

**1.** Method implemented by a device, called a centralising meter (120), included in an automated metering management system in the context of an electrical distribution service, the centralising meter (120) comprising a first powerline communication unit (304) configured for communicating with a data concentrator (110) via a first powerline communication network (100) in a first frequency band, the centralising meter (120) further comprising a second powerline communication unit (305) configured for communicating with a plurality of devices, called remote basic meters (131, 132, 133), via a second powerline communication network (101) in a second frequency band distinct from the first frequency band, the method comprising the following steps:

- emulating a smart electricity meter application (131, 132, 133) with respect to the data concentrator (110) for each remote basic meter (131, 132, 133) registered with the centralising meter (120) via the second powerline communication network (101), each emulated application (311, 312, 313) constructing a load curve for the corresponding remote basic meter (131, 132, 133);
- measuring, by a general metrology unit (320) of the centralising meter (120), the electrical consumption of all the electrical installations that the remote basic meters (131, 132, 133) are responsible for supervising;
- when the $\Delta Ea_D/\Delta Ea_G$ ratio of an energy consumption $\Delta Ea_D$ declared by all the remote basic meters (131, 132, 133) during a time T to an energy consumption $\Delta Ea_G$ measured by the general metrology unit (320) during the time T is below a predefined threshold and furthermore the load curves of a plurality of remote basic meters (131, 132, 133) show a drop to zero of the energy consumption, identifying which remote basic meter (131, 132, 133) is subject to an energy-consumption fraud, by extrapolating the load curves of said plurality of remote basic meters (131, 132, 133) and comparing the total energy consumptions $\Delta Ea_E$ estimated from the extrapolated load curves with said energy consumption $\Delta Ea_G$.

2. Method according to claim 1, wherein the estimated energy consumption $\Delta Ea_E$ includes a predetermined intrinsic consumption $\Delta E_C$ of the remote basic meters(131, 132, 133).

3. Method according to one of claims 1 and 2, wherein the centralising meter (120) identifies (807) the remote basic meter subject to the energy-consumption fraud as being the remote basic meter for which the estimated energy consumption $\Delta Ea_E$ is closest to the measured energy consumption $\Delta Ea_G$.

4. Method according to claim 3, wherein the centralising meter (120) identifies (807) the remote basic meter subject to the energy-consumption fraud as being the remote basic meter for which the following expression is minimum:

$$\left| 1 - \frac{\Delta Ea_E}{\Delta Ea_G} \right|$$

5. Method according to one of claims 1 and 2, wherein the centralising meter (120) identifies (807) the remote basic meter subject to the energy-consumption fraud as being the remote basic meter for which the following ratio is maximum:

$$\frac{\Delta Ea_E}{\Delta Ea_G}$$

6. Method according to any one of claims 1 to 5, wherein, when the load curves of a plurality of remote basic meters (131, 132, 133) show that the energy consumption has dropped to zero, the centralising meter (120) performs the following steps:

- recovering information on the state of each remote basic meter the load curve of which shows that the energy consumption has dropped to zero, by sending a dedicated atomic command frame to said remote basic meter by the emulated application (311, 312, 313) instanciated for said remote basic meter (131, 132, 133); and
- excluding from the extrapolations the load curve of each remote basic meter the recovered state information of which indicates that a breaker member of said remote basic meter is open and/or a downstream breaker of the electrical installation that said remote basic meter is responsible for supervising is open.

7. Method according to any one of claims 1 to 6, wherein the centralising meter, in performing each extrapolation, considers the load curve in question over a period equal to T/2 until the moment when the energy consumption drops to zero, where T represents a period between two successive metering index readings by the general metrology unit (320) for determining the energy consumption $\Delta Ea_G$.

8. Device, called a centralising meter (120), intended to be included in an automated metering management system in the context of an electrical distribution service, the centralising meter (120) comprising a first powerline communication unit (304) configured for communicating with a data concentrator (110) via a first powerline communication network (100) in a first frequency band, the centralising meter (120) further comprising:

- a second powerline communication unit (305) configured for communicating with a plurality of devices, called remote basic meters (131, 132, 133), via a second powerline communication network (101) in a second frequency band distinct from the first frequency band,

- a control unit (302) configured for emulating a smart electricity meter application (311, 312, 313) with respect to the data concentrator (110) for each remote basic meter (131, 132, 133) registered with the centralising meter (120) via the second powerline communication network (101), each emulated application (311, 312, 313) constructing a load curve for the corresponding remote basic meter (131, 132, 133),

- a general metrology unit (320) responsible for reading the electrical consumption of all the electrical installations that the remote basic meters (131, 132, 133) are responsible for supervising,

the control unit (302) comprising a metrology control module (315) which, when the ratio $\Delta Ea_D/\Delta Ea_G$ of an energy consumption $\Delta Ea_D$ declared by all the remote basic meters (131, 132, 133) during a time T to an energy consumption $\Delta Ea_G$ measured by the general metrology unit (320) during the time T is below a predefined threshold and when furthermore the load curves of a plurality of remote basic meters (131, 132, 133) show that the energy consumption has dropped to zero, is configured for identifying which remote basic meter (131, 132, 133) is subject to an energy-consumption fraud, by extrapolating the load curves of said plurality of remote basic meters (131, 132, 133) and comparing total consumptions $\Delta Ea_E$ estimated from the load curves extrapolated with said energy consumption $\Delta Ea_G$.

9. A computer program product comprising instructions that cause the device (120), according to claim 8, to perform the steps of the method according to one of claims 1 to 7.

10. A storage medium on which is recorded the computer program according to claim 9.

Fig. 1

Fig. 2

CM
120

IAPP
310

EAPP1
311

CTRL_A
302

EAPP2
312

UI_A
303

MCTRL
315

EAPP3
313

COM_A1
304

F1
306

GMTR
320

COM_A2
305

F2
307

Fig. 3A

RBM
130

FLG
370

WIF
360

RDSP
361

CTRL_B
352

MTR
353

COM_B
354

BRK
355

Fig. 3B

```
┌─────────┐                              ┌─────────┐
│ ┌─────┐ │                              │ ┌─────┐ │
│ │ RBM │ │                              │ │ CM  │ │
│ │ 130 │ │                              │ │ 120 │ │
│ └─────┘ │                              │ └─────┘ │
└─────────┘                              └─────────┘
     ┊                                        ┊
┌─────────────┐                               ┊
│Initialisation│                              ┊
│     400      │                              ┊
└─────────────┘                               ┊
     ┊                                        ┊
┌─────────────┐                         ┌─────────────┐
│   Balisage  │ ◄─────────────────────► │   Balisage  │
│     401     │                         │     451     │
└─────────────┘                         └─────────────┘
     ┊                                        ┊
┌─────────────┐                         ┌─────────────┐
│Enregistrement│◄─────────────────────► │Enregistrement│
│     402     │                         │     452     │
└─────────────┘                         └─────────────┘
     ┊                                  ┌─────────────┐
     ┊                                  │  Emulation  │
     ┊                                  │     453     │
     ┊                                  └─────────────┘
     ┊                                  ┌─────────────┐
     ┊                                  │Déclaration au DC│
     ┊                                  │     454     │
     ┊                                  └─────────────┘
┌────────────────┐                      ┌────────────────┐
│Découverte de route│◄─────────────────►│Découverte de route│
│     405        │                      │     455        │
└────────────────┘                      └────────────────┘
┌────────────────┐                      ┌────────────────┐
│Echanges applicatifs│◄────────────────►│Echanges applicatifs│
│     406        │                      │     456        │
└────────────────┘                      └────────────────┘
```

Fig. 4

```
┌─────────────┐                              ┌─────────────┐
│  ┌───────┐  │                              │  ┌───────┐  │
│  │  CM   │  │                              │  │  DC   │  │
│  │  120  │  │                              │  │  110  │  │
│  └───────┘  │                              │  └───────┘  │
└─────────────┘                              └─────────────┘
```

| Emulation 453 | |
| --- | --- |
| Balisage 501 | Balisage 551 |
| Enregistrement 502 | Enregistrement 552 |
| Découverte de route 503 | Découverte de route 553 |
| Echanges applicatifs 504 | Echanges applicatifs 554 |

Fig. 5

Relevé d'index de comptage local et auprès de chacun des compteurs basiques déportés rattachés — 601

Ecoulement temps T — 602

Relevé d'index de comptage local et auprès de chacun des compteurs basiques déportés rattachés — 603

Calcul de consommation globale mesurée, sous forme d'énergie active $\Delta Ea_G$ — 604

Calcul de consommation globale déclarée par les compteurs basiques déportés, sous forme d'énergie active $\Delta Ea_D$ — 605

Comparaison entre consommation globale mesurée $\Delta Ea_G$ et consommation globale déclarée $\Delta Ea_D$ — 606

oui — Ratio de comparaison supérieur ou égal à un seuil TH prédéfini ? — non

608

607

Identification du compteur basique déporté suspecté de fraude

Fig. 6

Relevé d'index de comptage auprès de chacun des compteurs basiques déportés rattachés ⌇701

Mise à jour de la courbe de charge de chacun des compteurs basiques déportés rattachés ⌇702

Ecoulement temps T' ⌇703

## Fig. 7

Analyse des courbes de charge ⌇801

Identification d'au moins un compteur basique déporté dont la consommation électrique est devenue nulle ⌇802

Récupération de l'état de chaque compteur basique identifié ⌇803

Exclusion de chaque compteur basique identifié dont l'état montre que l'alimentation électrique de l'installation électrique supervisée est effectivement coupée ⌇804

Extrapolations à partir des courbes de charge de chaque compteur basique identifié restant ⌇805

Calcul de consommations globale estimée, sous forme d'énergie active $\Delta Ea_E$ ⌇806

Identification du compteur basique déporté pour lequel une fraude à la consommation électrique est détectée ⌇807

## Fig. 8

**RÉFÉRENCES CITÉES DANS LA DESCRIPTION**

**Documents brevets cités dans la description**

- FR 3025600 A1
- US 8461823 B2
- US 2017082665 A1
- US 2015149396 A1